# EUROPEAN PATENT APPLICATION

(11) **EP 2 149 911 A2**
(43) Date of publication of application: **03.02.2010**
(21) Application number: 08018837.8
(22) Date of filing: 05.09.2006
(51) Int. Cl.: H01L 29/786

(54) **Field effect transistor having a channel comprising an oxide semiconductor material including indium and zinc**

(30) Priority: 16.09.2005 JP 2005271118; 17.03.2006 JP 2006075054; 21.08.2006 JP 2006224309
(62) Divisional of application: 06797776.9
(71) Applicant: Canon Kabushiki Kaisha, Tokyo (JP)
(72) Inventor: Iwasaki, Tatsuya, Tokyo (JP); Den, Toru, Tokyo (JP); Itagaki, Naho, Tokyo (JP)
(74) Representative: Weser, Thilo

(57) **Abstract**

Disclosed herein is a field-effect transistor comprising a channel comprised of an oxide semiconductor material including In and Zn. The atomic compositional ratio expressed by In/(In + Zn) is not less than 35 atomic% and not more than 55 atomic%. Ga is not included in the oxide semiconductor material or the atomic compositional ratio expressed by Ga/(In + Zn + Ga) is set to be 30 atomic% or lower when Ga is included therein. The transistor has improved S-value and field-effect mobility.

## Description

### TECHNICAL FIELD

The present invention relates to a field-effect transistor using an oxide semiconductor. In addition, the present invention relates to a display apparatus using an organic electroluminescence device, inorganic electroluminescence device or a liquid crystal device, and utilizing the transistor.

### BACKGROUND ART

A technique related to a TFT (thin film transistor) using an oxide semiconductor including In, Zn, and Ga for a channel is described in "Nature", Vol. 432, 25, November 2004 (pp. 488-492).

The article of "Nature", Vol. 432, 25, November 2004 (pp. 488-492) describes a technique for using an amorphous oxide semiconductor having an atomic compositional ratio of In : Ga : Zn = 1.1 : 1.1 : 0.9 (atomic ratio) for a channel layer of the TFT.

The inventors of the present invention have formed an oxide semiconductor film having a substantially equal atomic compositional ratio among In, Ga, and Zn by a sputtering method, and have determined that the oxide semiconductor film is available for the channel layer of TFT.

Then, in order to realize superior TFT devices, the inventors of the present invention studied the compositional dependence of In-Ga-Zn-O semiconductor in detail.

As a result, the present invention has been made in which an S-value and a field-effect mobility, each of which is one of evaluation items of transistor characteristics, can be improved by making the compositional ratio of Ga to In and Zn smaller than conventional atomic compositional ratios. In addition, In-Ga-Zn atomic compositional ratios which show excellent TFT characteristics in temporal stability and operating stability are technically disclosed.

### DISCLOSURE OF THE INVENTION

According to a first aspect of the present invention, there is provided a field-effect transistor including a channel made of an oxide semiconductor material including In and Zn, in which the atomic compositional ratio expressed by In/(In + Zn) is not less than 35 atomic% and not more than 55 atomic%, and Ga is not included in the oxide semiconductor material or the atomic compositional ratio expressed by Ga/(In + Zn + Ga) is 30 atomic% or lower when Ga is included therein.

Further, in the field-effect transistor, the compositional ratio expressed by Ga/(In + Zn + Ga) is 15 atomic% or lower.

Further, in the field-effect transistor, the atomic compositional ratio expressed by Ga/(In + Zn + Ga) is equal to or smaller than 5 atomic%.

Further, in the field-effect transistor, the atomic compositional ratio expressed by Ga/(In + Zn + Ga) is not less than 5 atomic% and not more than 15 atomic%.

With respect to the compositional ratio, it is preferable that the atomic compositional ratio expressed by In/(In + Zn) be 40 atomic% or higher or the compositional ratio be 50 atomic% or lower.

According to another aspect of the present invention, there is provided a field-effect transistor including a channel made of an oxide semiconductor including In and Zn, in which the oxide semiconductor has a composition in a region surrounded by a, f, i, and k shown in Table 1 below.

According to another aspect of the present invention, there is provided a field-effect transistor including a channel made of an oxide semiconductor including In and Zn, in which the oxide semiconductor has a composition in a region surrounded by S, n, k, and V shown in Table 1 below.

According to another aspect of the present invention, there is provided a field-effect transistor including a channel made of an oxide semiconductor including In and Zn, in which the oxide semiconductor has a composition in a region surrounded by R, e, q, and S shown in Table 1 below.

According to another aspect of the present invention, there is provided a field-effect transistor including a channel made of an oxide semiconductor including In and Zn, in which the oxide semiconductor has a composition on a line R-e shown in Table 1 below.

According to another aspect of the present invention, there is provided a field-effect transistor including a channel made of an oxide semiconductor including In and Zn, in which the oxide semiconductor has a composition in a region surrounded by n, g, U, and T shown in Table 1 below.

According to another aspect of the present invention, there is provided a field-effect transistor including a channel made of an oxide semiconductor including In and Zn, in which the oxide semiconductor has a composition in a region surrounded by Y, h, i, and k shown in Table 1 below.

According to another aspect of the present invention, there is provided a field-effect transistor including a channel made of an oxide semiconductor including In and Zn, in which the oxide semiconductor has a composition in a region surrounded by a, f, i, and k of the phase diagram shown in Table 1 with respect to In, Zn, and Ga and further includes Sn added thereto.

In particular, it is preferable that the ratio of Sn to the sum of In, Zn, Ga, and Sn which are included in the oxide semiconductor is 0.1 atomic% to 20 atomic%.

According to another aspect of the present invention, there is provided a transistor using an oxide semiconductor including In and Zn for a channel. The oxide semiconductor has an atomic compositional ratio expressed by In/(In + Zn) of 35 atomic% or higher and 45 atomic% or lower.

According to another aspect of the present invention, there is provided a transistor using an oxide semiconductor including In and Zn for a channel. The channel layer has a resistivity of 1 Ωcm or higher and 1 kΩcm or lower.

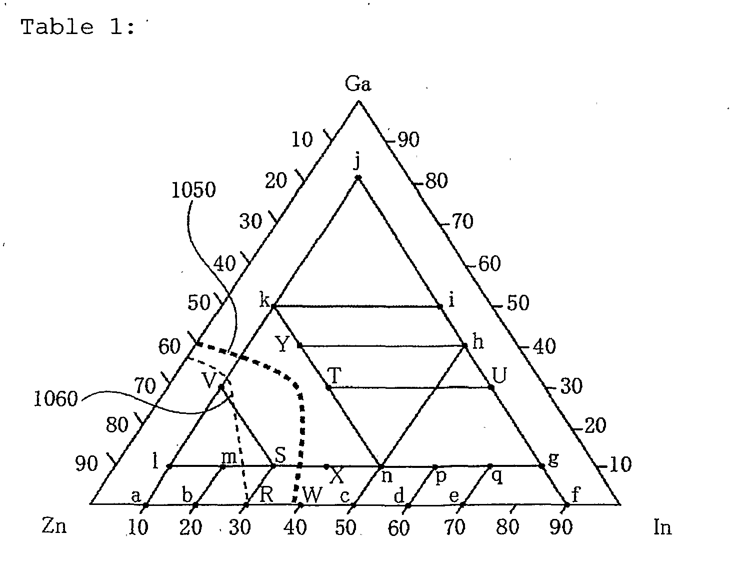

According to the present invention, a field-effect transistor whose transistor characteristics including field-effect mobility and S-value are excellent and whose reliability is high can be provided.

Further features of the present invention will become apparent from the following description of exemplary embodiments (with reference to the attached drawings).

### BRIEF DESCRIPTION OF THE DRAWINGS

FIG. 1 is an explanatory phase diagram showing an oxide according to the present invention;
FIG. 2 shows an example of a structure of a transistor according to the present invention;
FIG. 3 is a phase diagram showing a summary of results obtained in Example 1;
FIG. 4 is a phase diagram showing a summary of results obtained in Example 2;
FIG. 5 is a phase diagram showing a summary of carrier mobilities of TFTs based on results obtained in Examples 1 to 4;
FIG. 6 is a graph showing a relationship between the In-Zn compositional ratio and the resistivity of the In-Zn-O film produced in Example 3;
FIG. 7A is a graph showing a relationship between the compositional ratio of the In-Zn-O film of a TFT device produced in Example 3 and the carrier mobility, and FIG. 7B is a graph showing a relationship between the compositional ratio and the current ON/OFF ratio;
FIG. 8A is a graph showing a relationship between the compositional ratio of the In-Zn-O film of the TFT device produced in Example 3 and the threshold voltage, and FIG. 8B is a graph showing a relationship between the compositional ratio and the sub-threshold swing value (S-value);
FIG. 9 is a graph showing a transfer characteristic of the TFT device produced in Example 3;
FIG. 10 is an explanatory phase diagram showing an oxide according to the present invention;
FIGS. 11A and 11B show structural examples of a thin film transistor according to the present invention (i.e., sectional views);
FIGS. 12A and 12B show graphs of TFT characteristics of the thin film transistor according to the present invention;
FIGS. 13A and 13B show graphs of hysteresis characteristics of the thin film transistor according to the present invention;
FIG. 14 is a graph showing a relationship between an electron carrier concentration of an amorphous oxide film of In-Ga-Zn-O and an oxygen partial pressure during film formation;
FIGS. 15A, 15B, 15C, and 15D show graphs of a relationship between an oxygen flow rate in an atmosphere during film formation on the In-Zn-O film of the TFT device produced in Example 3 and each of TFT characteristics thereof;
FIG. 16 is a phase diagram showing a summary of results obtained in Example 3;
FIG. 17 is a phase diagram showing a summary of results obtained in Example 4;
FIG. 18 is a phase diagram showing a summary of the results obtained in Examples 1 to 4;
FIG. 19 is a graph showing a temporal change in resistivity of the In-Zn-O film produced in Example 3;
FIG. 20 is a graph showing a temporal change in TFT characteristic of the thin film transistor produced in Example 3;
FIG. 21 is a graph showing a temporal change in resistivity of an In-Ga-Zn-O film produced in Example 4;
FIG. 22 is a graph showing a temporal change in TFT characteristic of a thin film transistor produced in Example 4;
FIG. 23 is a graph showing a temporal change in resistivity of an In-Ga-Zn-O film produced in Example 4;
FIGS. 24A, 24B, and 24C show graphs of TFT characteristics, obtained before and after an application of a DC bias stress, of the thin film transistor produced in Example 1; and
FIG. 25 shows graphs of TFT characteristics obtained before and after the application of the DC bias stress, of the thin film transistor produced in Example 3.

### BEST MODE FOR CARRYING OUT THE INVENTION

### (First Embodiment)

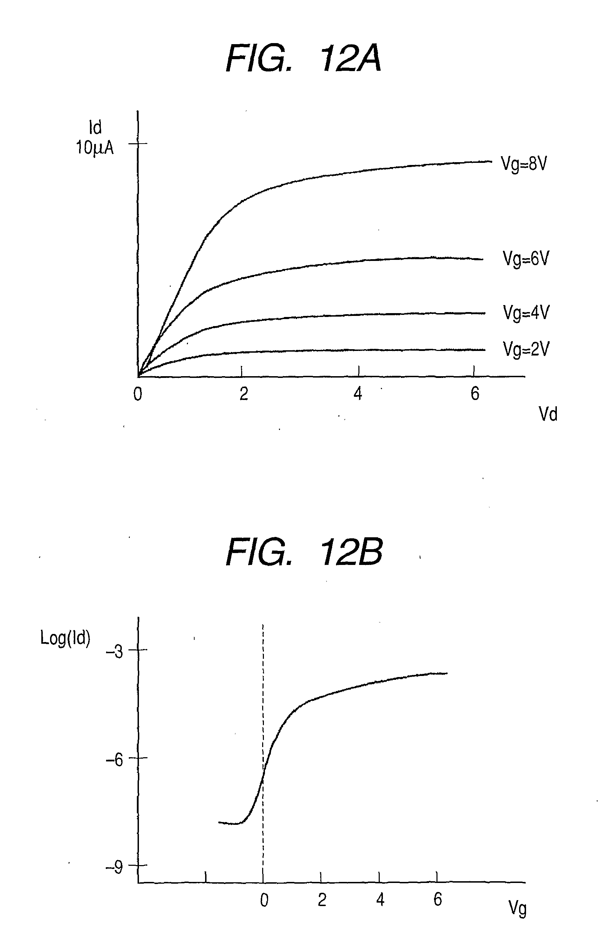

First, the S-value which is one of evaluation items of transistor operating characteristics will be described. FIGS. 12A and 12B show typical characteristics of a field-effect transistor according to the present invention.

While a voltage Vd of approximately 5 V to 20 V is applied between a source electrode and a drain electrode, switching a gate voltage Vg to be applied between 0 V and 5 V to 20 V can control a current Id flowing between the source electrode and the drain electrode (i.e., ON/OFF operations).

FIG. 12A shows an example of an Id-Vd characteristic with changing Vg and FIG. 12B shows an example of an Id-Vg characteristic (i.e., transfer characteristic) at Vd = 6 V.

There are various evaluation items of the transistor characteristics. For example, there are field-effect mobility µ, threshold voltage (Vth), ON/OFF ratio, S-value, and the like.

The field-effect mobility can be obtained from a characteristic in a linear region or a characteristic in a saturation region. For example, there is a method of creating a √Id-Vg graph based on a result of the transfer characteristic and deriving a field-effect mobility from the gradient of the graph. In this specification, a field-effect mobility is evaluated using this method unless otherwise specified.

Several methods are used to obtain the threshold value. For example, there is a method of deriving the threshold voltage Vth from an x-intercept of the √Id-Vg graph.

The ON/OFF ratio can be obtained based on a ratio between a maximum Id value and a minimum Id value in the transfer characteristic.

The S-value can be derived from a reciprocal of a gradient of a Log(Id)-Vd graph created based on the result of the transfer characteristic.

The unit of the S-value is V/decade and it is preferable that the S-value be a small value.

### (Mode 1 of Channel Layer: In-Ga-Zn-O System)

First, a preferable compositional range in the case where an In-Ga-Zn-O material is used for an active layer will be described.

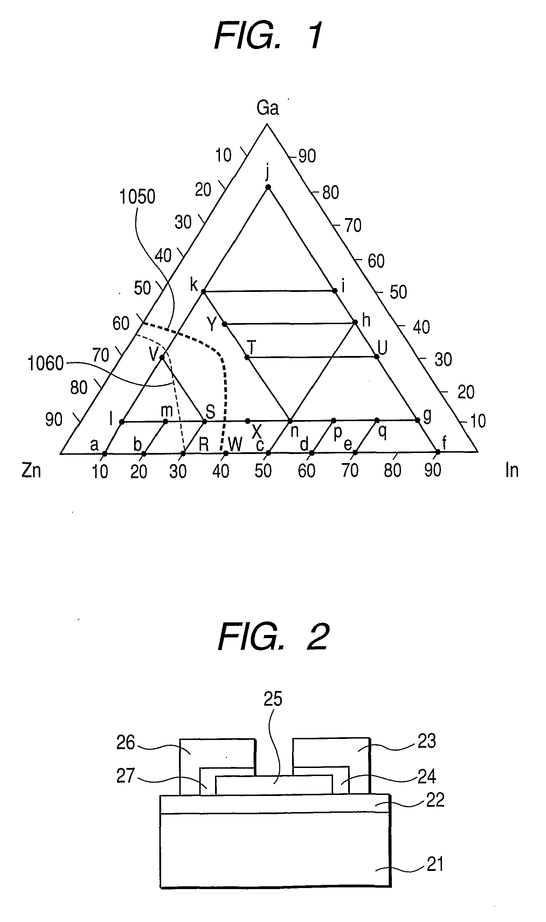

An fabrication and evaluation method will be described in detail later in Examples 1 to 4.By using combinatorial techniques, a large number of devices including active layers whose compositions are different from one another are formed on the single substrate. Then, the formed devices are evaluated. According to such a method, the dependency of transistor characteristics on a composition of the active layer can be determined. The structure of each field-effect transistor (FET) is a bottom-gate top-contact type as shown in FIG. 2 in which n⁺-Si, SiO₂, are used for a gate electrode and an gate-insulating layer and Au/Ti is used for a source electrode and a drain electrode, respectively. The channel width and channel length are 150 µm and 10 µm, respectively. The source-drain voltage used for the FET evaluation is 6 V.

In the TFT characteristic evaluation, the electron mobility is obtained based on the gradient of √Id (Id: drain current) to the gate voltage (Vg) and the current ON/OFF ratio is obtained based on the ratio between the maximum Id value and the Id minimum value. The intercept on the Vg-axis in the plot of √Id to Vg is taken as the threshold voltage.

A minimum value of dVg/d(log Id) is taken as the S-value (i.e., voltage value necessary to increase current by one order of magnitude).

In order to evaluate the operating stability, the stress test is carried out to the TFT. For 400 seconds, a DC voltage stress of 12 V is applied to the gate electrode and a DC voltage stress of 12 V is applied between the source electrode and the drain electrode. Changes in TFT characteristics are evaluated to evaluate DC bias stress resistance (i.e., operating stability). The difference of the threshold voltage between before and after the DC bias stress (i.e., threshold shift)is evaluated.

As a reference device, a thin film transistor including an active layer made of an oxide semiconductor material of In : Ga : Zn = 1 : 1 : 1 is produced and the transistor characteristics thereof are evaluated. As a result, the S-value is approximately 1.2 (V/decade). In addition, the field-effect mobility is approximately 5 cm²/Vs and the threshold shift caused by the DC bias stress is approximately 2.7 V.

Next, thin film transistors including active layers with various Ga compositional ratios are produced and compared with one another. An oxide semiconductor material in which a Ga atomic compositional ratio expressed by Ga/(In + Ga + Zn) is 30 atomic% is used and transistor characteristics are estimated. As a result, the field-effect mobility exceeds 7 cm²/Vs. When an oxide material in which the Ga compositional ratio is 15 atomic% is used, the field-effect mobility exceeds 12 cm²/Vs. That is, when the Ga compositional ratio is reduced, a thin film transistor having a large field-effect mobility can be realized.

When the Ga atomic compositional ratio expressed by Ga/(In + Ga + Zn) is 30 atomic%, the S-value shows approximately 1.2 (V/decade). When the Ga compositional ratio is 15 atomic%, the S-value showed 1 (V/decade). That is, when the Ga compositional ratio is reduced, a thin film transistor having a small S-value can be realized.

When the Ga compositional ratio expressed by Ga/(In + Ga + Zn) is 30 atomic%, the threshold shift caused by the DC bias stress is approximately 2.6 V. When the Ga compositional ratio is 15 atomic%, the threshold shift is equal to or smaller than 1 V. That is, when the Ga compositional ratio is reduced, a thin film transistor having a small threshold shift under the the DC bias stress can be realized.

Next, preferable compositional ratio of In and Zn will be described. Ina phase diagram shown in Figure1, a change in S-value within a range of a b-point to an e-point in the case where Ga is not included is as follows.

**Table 2**

| | b-point | R-point | W-point | c-point | d-point | e-point |
|---|---|---|---|---|---|---|
| In/(In + Zn) | 20% | 30% | 40% | 50% | 60% | 70% |
| S-value (V/decade) | - | 0.7 | 0.2 | 0.3 | 0.6 | - |

The fact that In/(In + Zn) = 20 atomic% means that the In-atomic compositional ratio is 0.2, that is, In : Zn = 0.2 : 0.8. Although the S-value at the W-point is shown to be approximately 0.2, the actual value is 0.16 as described later in examples. S-values at the b-point and the e-point cannot be evaluated because a transistor operation is not performed.

As is apparent from the above-mentioned result, when the compositional ratio is controlled between around the W-point and around the c-point, an extremely low S-value can be realized.

As can be further seen from that, when the In compositional ratio which is expressed by In/(In + Zn) becomes 35 atomic% or higher, the S-value significantly reduces. In addition to this, when the compositional ratio becomes 55 atomic% or lower, the S-value significantly reduces.

That is, when the In atomic compositional ratio expressed by In/(In + Zn) is set to be not less than 35 atomic% and not more than 55 atomic%, an oxide semiconductor having an extremely small S-value can be obtained.

The above-mentioned range is more preferably a range of 40 atomic% to 50 atomic%.

In the case of an oxide semiconductor including 10 atomic% Ga, S-values at the m-point, S-point, n-point, and p-point are obtained in the same manner. A TFT operation is not performed in the case of the m-point. The S-value at each of the S-point and the n-point is 0.7 and the S-value at the p-point is 0.8.

Therefore, in order to obtain the thin film transistor having the small S-value, it is preferable that the amount of Ga included in the oxide semiconductor is small. To be specific, it is desirable that the Ga atomic compositional ratio expressed by Ga/(In + Zn + Ga) is 0.30 or lower (i.e., 30 atomic% or lower), preferably 0.15 or lower (i.e., 15 atomic% or lower), and more preferably 0.05 or lower (i.e., 5 atomic% or lower).

The field-effect mobilities at the W-point and the c-point exceed 15 (cm²/Vs).

The threshold shift caused by the DC bias stress is approximately 0.7 V. Therefore, it is found that a preferable stress resistance is obtained.

The good influence caused by a reduction in the amount of Ga was described above. There is also good influences caused by an increase in the amount of Ga. These will be described below.

As described above, when Ga is 0 atomic%, the range of the ratio expressed by In/(In + Zn) in which the transistor operation is exhibited is within from 30 atomic% to 60 atomic%. When the amount of Ga is increased so that the Ga atomic compositional ratio expressed by Ga/(In + Ga + Zn) is 15 atomic%, the transistor operation is exhibited in the compositional range of the In atomic compositional ratio expressed by In/(In + Ga + Zn) of 22.5 atomic% or higher and 57.5 atomic% or lower. When the amount of Ga is increased so that the Ga atomic compositional ratio expressed by Ga/(In + Ga + Zn) is 30 atomic%, the transistor operation (switching operation)is exhibited in the compositional range of the In atomic compositional ratio expressed by In/(In + Ga + Zn) of 10 atomic% or higher and 60 atomic% or lower. When the range of the In atomic compositional ratio expressed by In/(In + Ga + Zn) is 10 atomic% or lower, a current (Id) cannot be enhanced by the positive gate bias. In addition, when the range of the In compositional ratio is 60 atomic% or higher, a relatively large current flows and cannot depressed even by a negative gate bias. Under these In compositional ratios, a current ON/OFF ratio of 10⁵ or higher cannot be obtained. Therefore, as the Ga compositional ratio is increased, there is such a merit that the compositional design range (i.e., compositional range which can be adapted for the transistor) of the composition ratio of In : Zn widens.

In view of environmental stability, it is preferable that the mount of Ga is large.

Temporal stability of a resistivity of the oxide semiconductor which is left in the atmosphere is evaluated at each of the W-point and the c-point in which Ga is 0 atomic%. As a result, when initial resistivity of the oxide semiconductor is low (i.e., less than 100 Ωcm), a change in resistivity is hardly observed. In contrast to this, when the initial resistivity of the oxide semiconductor is high, the tendency of a temporal reduction in resistivity is observed.

The initial resistivity means a value of resistivity measured immediately after the formation of the oxide semiconductor films. The initial resistivity of the oxide semiconductor can be controlled based on a film formation condition including an oxygen partial pressure during film formation.
Next, the temporal stability of the resistivity of the oxide semiconductor including 10 atomic% Ga is evaluated at each of the S-point and the n-point in the same manner. As a result, even when the initial resistivity of the oxide semiconductor is high, the resistivity is temporally stable. Further, there are almost no temporal changes in transistor characteristics such as the threshold voltage and the OFF current, when the above oxide semiconductors are applied to the TFT.

As a result of intensive studies by the inventors of the present invention, there is the tendency to exhibit that, when the oxide semiconductor having high resistivity is applied to the channel layer, so-called "normally-off characteristic" is achieved. The "normally-off characteristic" means that the threshold voltage is positive and a current does not flow (transistor is off-state)at the time when the gate voltage is not applied. From this viewpoint, it is preferable to use an oxide semiconductor in which a temporal change in resistivity thereof is small, because a thin film transistor in which temporal changes in threshold voltage and OFF current are small can be realized.

Thus, in order to obtain an oxide semiconductor which has a relatively high threshold and is excellent in temporal stability, it is necessary to include a certain amount of Ga in the oxide semiconductor. To be specific, it is desirable that the Ga atomic compositional ratio expressed by Ga/(In + Zn + Ga) be 5 atomic% or higher.

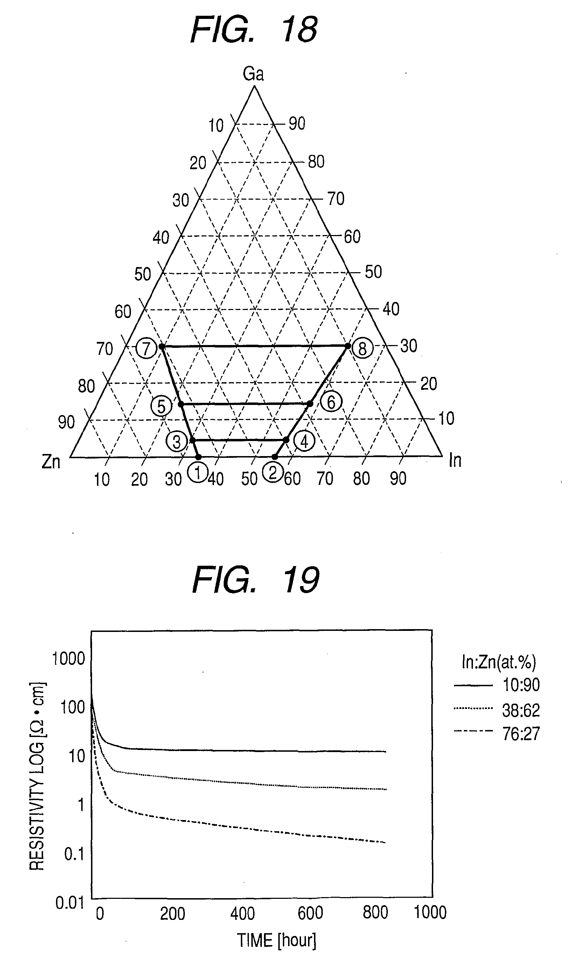

Hereinafter, the above-mentioned preferable compositional ranges will be summarized using FIG. 18.

Note that a ternary phase diagram of FIG. 18 shows ratios (i.e., atomic percent) among In, Ga, and Zn which are included in the In-Ga-Zn-O oxide semiconductor. The amount of oxygen is not taken into account.

In the figure, the amount of oxygen is not described. For example, when it is assumed that In is trivalent, Ga is trivalent, and Zn is divalent, a stoichiometry and compositions therearound are mentioned. The deviation from the stoichiometry (i.e., the number of oxygen defects) can be controlled based on, for example, the oxygen pressure during film formation as described later.

In the ternary phase diagram, for example, a point (1) indicates that the ratio of Zn to the sum of Zn and In which are included in the oxide semiconductor is 65 atomic% and the ratio of In thereto is 35 atomic%. The compositional ratio (atomic%) at each point is shown below.

| | |
|---|---|
| Point (1) | In : Ga : Zn = 35 : 0 : 65 |
| Point (2) | In : Ga : Zn = 55 : 0 : 45 |
| Point (3) | In : Ga : Zn = 30.8 : 5 : 64.2 |
| Point (4) | In : Ga : Zn = 55.8 : 5 : 39.2 |
| Point (5) | In : Ga : Zn = 22.5 : 15 : 62.5 |
| Point (6) | In : Ga : Zn = 57.5 : 15 : 27.5 |
| Point (7) | In : Ga : Zn = 10 : 30 : 60 |
| Point (8) | In : Ga : Zn = 60 : 30 : 10 |

When an In-Ga-Zn-O thin film having a composition in the compositional region surrounded by lines joining the points (1), (2), (8), and (7) on the phase diagram shown in FIG. 18 is used as the channel layer, it is possible to provide a transistor having a field-effect mobility higher than that of a conventional one (In:Ga:Zn=1:1:1).

Further, when an In-Ga-Zn-O thin film having a composition in the compositional region which is within the above-mentioned compositional region and surrounded by lines joining the points (1), (2), (6), and (5) on the phase diagram shown in FIG. 18 is particularly used as the channel layer, it is possible to provide a transistor having excellent transistor characteristics and a preferable DC bias stress resistance as compared with a conventional one.

Further, when an In-Ga-Zn-O thin film having a composition in the compositional region which is within the above-mentioned compositional region and surrounded by lines joining the points (1), (2), (4), and (3) on the phase diagram shown in FIG. 18 is particularly used as the channel layer, it is possible to provide a transistor having excellent transistor characteristics and an extremely small S-value as compared with a conventional one.

Further, when an In-Ga-Zn-O thin film having a composition in the compositional region which is within the above-mentioned compositional region and surrounded by lines joining the points (3), (4), (6), and (5) on the phase diagram shown in FIG. 18 is particularly used as the channel layer, it is possible to provide a transistor having excellent transistor characteristics and temporal stability which are superior to a conventional one.

### (Structure of Field-Effect Transistor)

The structure of a field-effect transistor which can be used in the present invention will be described. Note that the S-value and the like which are described above are results obtained by measurement in the case where the structure shown in FIG. 2 is used and the channel length L and channel width W are set to 10 µm and 150 µm, respectively.

FIG. 2 shows an example of a bottom gate type transistor.

In FIG. 2, reference numeral 21 denotes a substrate (n⁺-Si substrate which also serves as a gate electrode), '22' denotes an gate insulating layer (SiO₂), and '25' denotes a channel (oxide semiconductor). Reference numerals 24 and 27 denote first electrodes (made of, for example, Ti) and 23 and 26 denote second electrodes (made of Au). Note that Ni instead of Ti may be used for the first electrodes.

The thickness of the oxide semiconductor (channel) in the above-mentioned embodiment is in a range of 10 nm to 200 nm, preferably in a range of 20 nm to 100 nm. The thickness is more preferably in a range of 30 nm to 70 nm.

It is preferable to use a vapor phase deposition method such as a sputtering method (SP method), a pulse laser deposition method (PLD method), an electron beam deposition method, an atomic layer deposition method, as a method of forming the films. Of the vapor phase deposition methods, the SP method is suitable in view of mass productivity. However, the film forming method is not limited to those methods. The temperature of a substrate during film formation can be maintained to substantially a room temperature without intentionally heating the substrate.

In order to obtain preferable TFT characteristics in a thin film transistor in which an amorphous oxide semiconductor is used for a channel layer thereof, the following is performed.

That is, it is preferable that a semi-insulating amorphous oxide semiconductor film having an electric conductivity of 10 S/cm or lower and 0.0001 S/cm or higher be applied to the channel layer.These amorphous oxide semiconductor films have an electron carrier concentration of approximately 10¹⁴ /cm³ to 10¹⁸ /cm³, although the carrier concentration depends on the material composition of the channel layer.

When the electric conductivity is 10 S/cm or higher, a normally-off transistor cannot be produced and a large ON/OFF ratio cannot be obtained. In an extreme case, even when the gate voltage is applied, current flowing between the source electrode and the drain electrode is not switched ON/OFF, so the transistor operation is not exhibited. On the other hand, in the case of an insulator, that is, in the case where the electric conductivity is 0.0001 S/cm or lower, a large on-current cannot be obtained. In an extreme case, even when the gate voltage is applied, current flowing between the source electrode and the drain electrode is not switched ON/OFF, so the transistor operation is not exhibited.

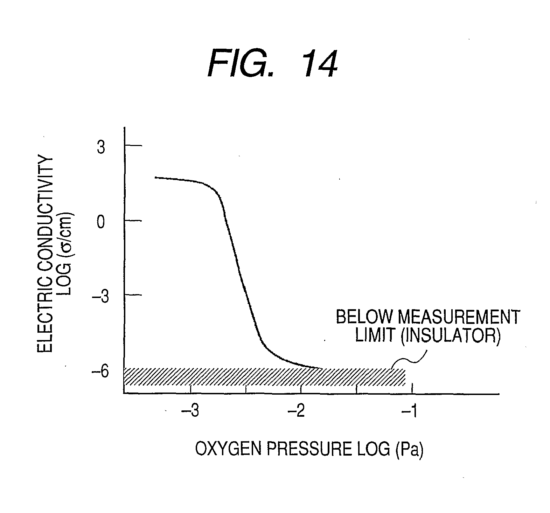

The electric conductivity of the oxide semiconductor and the electron carrier concentration thereof are controlled by oxygen partial pressure during film formation. That is, the number of oxygen defects in the oxide semiconductor films is mainly controlled by controlling the oxygen partial pressure, thereby controlling the electron carrier concentration. FIG. 14 is a graph showing an example of dependency of carrier concentration on oxygen partial pressure in the case where an In-Ga-Zn-O oxide semiconductor thin film is formed by a sputtering method.

When the oxygen partial pressure is controlled with high precision, it is possible to obtain a semi-insulating film which is a semi-insulating amorphous oxide semiconductor film having an electron carrier concentration of approximately 10¹⁴ /cm³ to 10¹⁸ /cm³. Then, when such a thin film is applied to the channel layer, a preferable TFT can be produced. As shown in FIG. 14, film formation is performed typically at an oxygen partial pressure of appropriately 0.005 Pa, the semi-insulating thin film can be obtained.

When the oxygen partial pressure is 0.001 Pa or lower, the electric conductivity is too high. On the other hand, when the oxygen partial pressure is 0.01 Pa or higher, the film becomes an insulator. Therefore, there is the case where such a film is not suitable as the channel layer of a transistor.

The preferable oxygen partial pressure depends on the material composition of the channel layer.

The phase diagram shown in FIG. 1 shows ratios (atomic ratio) among In, Ga, and Zn which are included in the oxide semiconductor. The amount of oxygen is not taken into account. For example, a point "a" on the phase diagram indicates that the ratio of Zn to the sum of Zn and In which are included in the oxide semiconductor is 90 atomic% and a ratio of In thereto is 10 atomic%.

Although regions indicated with the broken line in FIG. 1 are slightly changed by the amount of oxygen included in the oxide semiconductor, the region located on the left side of the broken line is a crystalline region or a region showing high crystallinity and the region located on the right side thereof is an amorphous region.

As for the material of the source electrode, drain electrode and gate electrode, it is possible to use a transparent conductive film made of In₂O₃:Sn, ZnO, or the like or a metal film made of Au, Pt, Al, Ni, or the like.

The thickness of the gate insulating layer is, for example, approximately 50 nm to 300 nm.

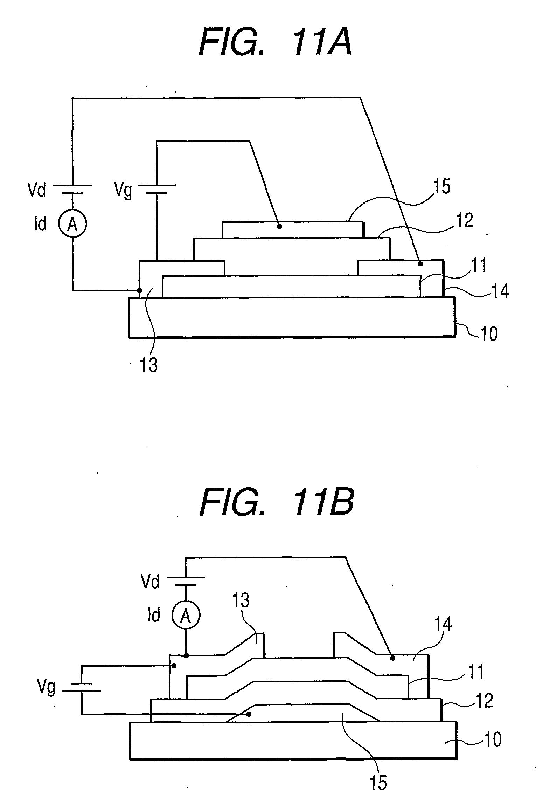

FIGS. 11A and 11B show other structural examples of the field-effect transistor.

FIGS. 11A and 11B are cross sectional views. In the drawings, reference numeral 10 denotes a substrate, '11' denotes a channel layer, '12' denotes a gate insulating layer, '13' denotes a source electrode, '14' denotes a drain electrode, and '15' denotes a gate electrode.

The field-effect transistor has a three-terminal device including the gate electrode 15, the source electrode 13, and the drain electrode 14.

This device is an electronic active device having a function for controlling a current Id flowing into the channel layer based on a voltage Vg applied to the gate electrode to switch ON and OFF the current Id flowing between the source electrode and the drain electrode.

FIG. 11A shows an example of a top-gate structure in which the gate insulating film 12 and the gate electrode 15 are formed on the semiconductor channel layer 11 in this order. FIG. 11B shows an example of a bottom-gate structure in which the gate insulating film 12 and the semiconductor channel layer 11 are formed on the gate electrode 15 in this order. In view of the configuration relationship between the electrodes and the channel layer-insulating layer interface, the structure shown in FIG. 11A is called a stagger structure and the structure shown in FIG. 11B is called an inverted stagger structure.

The TFT structure in the present invention is not limited to the above-mentioned structures. Therefore, a top-gate structure, a bottom-gate structure, a stagger structure, or an inverted stagger structure can be arbitrarily used.

A glass substrate, a plastic substrate, a plastic film, or the like can be used as the substrate 10.

For the material of the gate insulating layer 12, any insulating materials are applicable. For example, one compound selected from the group consisting of Al₂O₃, Y₂O₃, SiO₂, and HfO₂, or a mixed compound including at least two of those compounds can be used for the gate insulating layer 12.

For the material of each of the source electrode 13, the drain electrode 14, and the gate electrode 15, any conductive materials are applicable. For example, it is possible to use a transparent conductive film made of In₂O₃:Sn, ZnO, or the like or a metal film made of Au, Pt, Al, Ni, or the like.

When transparent materials are used for the channel layer, the gate insulating layer, the electrodes and the substrate, a transparent thin film transistor can be produced.

The evaluation items of transistor characteristics include a hysteresis evaluation.

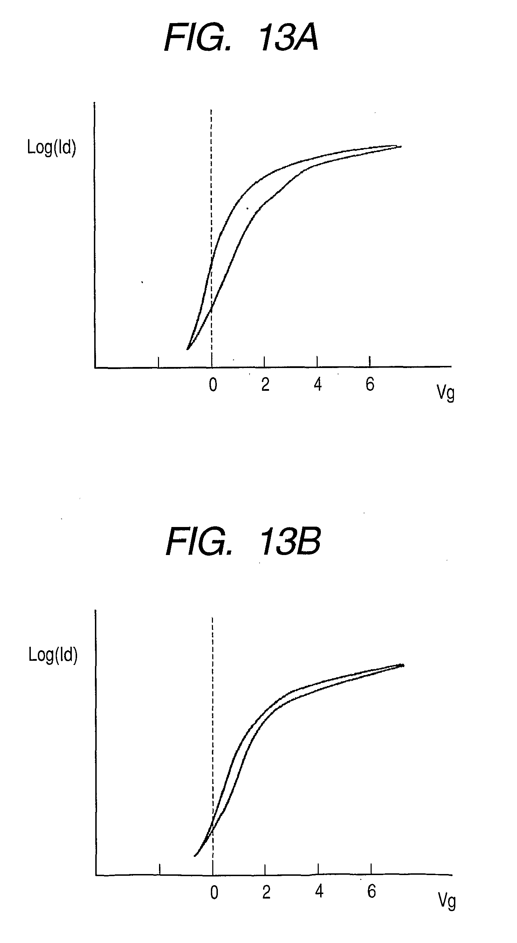

Hysteresis will be described with reference to FIGS. 13A and 13B. The hysteresis means that, when Vg is swept (i.e., increased and reduced) while Vd is held constant as shown in each of FIGS. 13A and 13B in the evaluation of the TFT transfer characteristic, Id exhibits different values at the times of rising and falling of voltage. When the hysteresis is large, the value of Id obtained corresponding to Vg varies. Therefore, a device having small hysteresis is preferable. FIG. 13A shows an example in which the hysteresis is large and FIG. 13B shows an example in which the hysteresis is small.

### (Preferable Composition Example of Channel Layer)

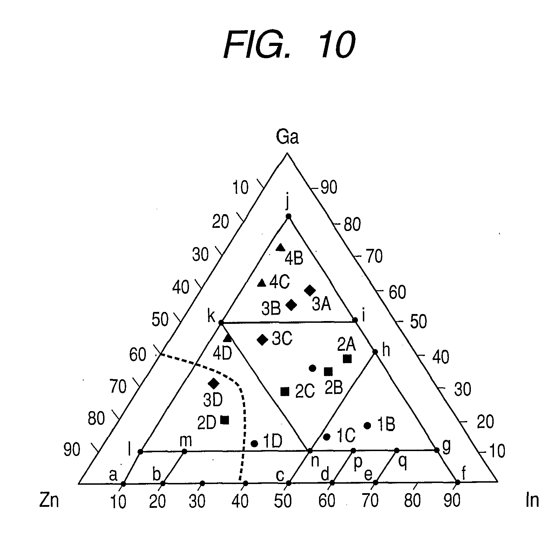

The preferable material composition of the active layer is described earlier. The following compositional range can also be a preferable compositional range. Next, a preferable compositional ratio in the case where an In-Ga-Zn oxide semiconductor is used for the channel layer of a TFT will be described with reference to the phase diagrams shown in FIGS. 1 and 10.

Each of the ternary phase diagrams shown in FIGS. 1 and 10 shows ratios (atomic%) among In, Ga, and Zn which are included in the In-Ga-Zn-O oxide semiconductor. The amount of oxygen is not taken into account.

For example, when it is assumed that In is trivalent, Ga is trivalent, and Zn is divalent, a stoichiometry and compositions therearound are applied. The deviation from the stoichiometry (i.e., the number of oxygen defects) can be controlled based on, for example, an oxygen pressure during film formation as described later.

In the ternary phase diagrams, for example, the point "a" indicates that the ratio of Zn to the sum of Zn and In which are included in the oxide semiconductor is 90 atomic% and the ratio of In thereto is 10 atomic%. The atomic percent which is the compositional ratio at each point is shown below.

| | |
|---|---|
| Point "a" | In : Ga : Zn = 10 : 0 : 90 |
| Point "b" | In : Ga : Zn = 20 : 0 : 80 |
| Point "c" | In : Ga : Zn= 50 : 0 : 50 |
| Point "d" | In : Ga : Zn = 60 : 0 : 40 |
| Point "e" | In : Ga : Zn = 70 : 0 : 30 |
| Point "f" | In : Ga : Zn = 90 : 0 : 10 |
| Point "g" | In : Ga : Zn = 80 : 10 : 10 |
| Point "h" | In : Ga : Zn = 50 : 40 : 10 |
| Point "i" | In : Ga : Zn = 40 : 50 : 10 |
| Point "j" | In : Ga : Zn = 10 : 80 : 10 |
| Point "k" | In : Ga : Zn = 10 : 50 : 40 |
| Point "l" | In : Ga : Zn = 10 : 10 : 80 |
| Point "m" | In : Ga : Zn = 20 : 10 : 70 |
| Point "n" | In : Ga : Zn = 50 : 10 : 40 |
| Point "p" | In : Ga : Zn = 60 : 10 : 30 |
| Point "q" | In : Ga : Zn = 70 : 10 : 20 |
| Point "R" | In : Ga : Zn = 30 : 0 : 70 |
| Point "S" | In : Ga : Zn = 30 : 10 : 60 |
| Point "T" | In : Ga : Zn = 30 : 30 : 40 |
| Point "U" | In : Ga : Zn = 60 : 30 : 10 |
| Point "V" | In : Ga : Zn = 10 : 30 : 60 |
| Point "W" | In : Ga : Zn = 40 : 0 : 60 |
| Point "X" | In : Ga : Zn = 40 : 10 : 50 |
| Point "Y" | In : Ga : Zn = 20 : 40 : 40 |

Although the regions indicated by the broken line in FIG. 1 are slightly changed by the amount of oxygen included in the oxide semiconductor, a film formation method, or the like, the region located on the left side of the broken line is the crystalline region or the region showing high crystallinity and the region located on the right side thereof is the amorphous region. The boundary between the crystal phase and the amorphous phase may be shifted depending on film formation conditions including film thickness and so on, so the shiftable range is indicated by two broken lines (1050 and 1060).

That is, the crystalline region and the amorphous region are separated from each other at arbitrary compositions between the two broken lines depending on the film formation condition. For example, in the case of a sputtering film formation method, the position of the boundary may be shifted depending on the distance between a target and a material and the gas pressure.

First, there is a compositional region surrounded by lines joining the points "a", "f", "i", and "k" on the phase diagram shown in FIG. 1. When an In-Ga-Zn-O thin film having a composition in this compositional region is used as the channel layer, it can have the thin film transistor function. Therefore, when an arbitrary composition is selected within the region, it is possible to provide a transistor having desirable characteristics.

A composition in a compositional region which is within the above-mentioned compositional region and surrounded by lines joining the points "S", "n", "k", and "V" on the phase diagram shown in FIG. 1 is particularly preferable. When an amorphous material having a composition in this compositional region is used for the channel layer, it is possible to realize a device having a relatively high mobility and a threshold voltage close to 0 V. In particular, there is an advantage that a transistor having preferable characteristics can be produced with high reproducibility. Although the reason why the transistor can be produced with high reproducibility is not known, it can be expected that the transistor is excellent in stability to a vacuum atmosphere and a temperature during film formation and environments after film formation. That is, the region of the composition is a region useful in the case where a device requires both the stability and the relatively large mobility.

In addition, there is an "R"-"e" range on the phase diagram shown in FIG. 1, that is, a range in which Ga is not present and the atomic compositional ratio expressed by In/(Zn + In) is 30 atomic% to 70 atomic%.

When an amorphous film of In-Zn-O in this range is applied to the channel layer, it is possible to realize a thin film transistor whose field-effect mobility is large, S-value is small, and ON/OFF ratio is large.

There is an another advantage. When the oxygen pressure during oxide semiconductor film formation is changed the changes in TFT characteristics is changed are small. This means that a process margin in the film preparing condition is wide. In this range, the vicinity of the point "W", i.e. the range in which the ratio expressed by Zn/(Zn + In) is 60 ± 5 atomic%, is particularly preferable, so a transistor whose S-value is small and ON/OFF ratio is large can be realized.
This composition is preferable in view of controlling the threshold voltage to a value close to 0 V in transistor characteristics. As a result of intensive studies by the inventors of the present invention, when the atomic compositional ratio expressed by Zn/(Zn + In) is 70 atomic% or higher, a crystallized thin film is obtained. The crystallized film degrades the TFT characteristics. On the other hand, when the atomic compositional ratio expressed by Zn/(Zn + In) is 30 atomic% or lower, only films having a small resistivity are formed, which are not preferable to the channel of the TFT having a high ON/OFF ratio, although the films are an amorphous state.

In addition, a composition in the compositional region surrounded by lines joining the points "R", "e", "q", and "S" on the phase diagram shown in FIG. 1 is preferable. This compositional region has both the feature of the second aspect and the feature of the third aspect as described earlier. That is, a transistor whose mobility is relatively large, ON/OFF ratio is large, S-value is small, and characteristics are excellent can be produced with high reproducibility.

In the above-mentioned compositional region, the region surrounded by lines joining the points "R", "c", "n", and "S" is particularly preferable because the ON/OFF ratio is large.

In this compositional region, various transistor characteristics (such as mobility, ON/OFF ratio, S-value, hysteresis, and stability) are generally preferable (i.e., balanced), so applications are possible in a wide range.

In addition, there is a compositional region surrounded by lines joining the points "n", "g", "U", and "T" on the phase diagram shown in FIG. 1. This region is a region in which a transistor having a negative threshold is easily produced. Also, an on-current is relatively large and hysteresis is small. That is, a composition in the region is useful in the case where the transistor having a negative threshold (i.e., normally-on type) is to be used.

In addition, there is a compositional region surrounded by lines joining the points "Y", "h", "i", and "k" on the phase diagram shown in FIG. 1. This compositional region is a region in which a transistor, having a positive threshold is easily produced. A characteristic in which an OFF current is relatively-small can be obtained. The reason why the characteristic can be obtained is not known. However, it can be expected that, in this compositional region, such a condition that the films having the small carrier concentration can be stably produced, while the mobility of an oxide semiconductor material is relatively small.

Because the Ga composition is relatively large, there is also an advantage that the optical absorption edge is shifted to shorter wavelengths and thus the optical transparency is high at a wavelength around 400 nm. The reflective index becomes smaller. That is, this compositional region is useful in the case where a device requires not a large on-current but a small OFF current or high transparency.

In addition, the condition that the atomic compositional ratio expressed by In/(In + Zn) is 35 atomic% or higher and 45 atomic% or lower is mentioned. In the compositional ratio between In and Zn, preferable transistor characteristics are exhibited without depending on the concentration of Ga in the Ga concentrations. In particular, this region is a region in which both a high mobility and a small S-value can be obtained.

In addition, a transistor in which an oxide semiconductor including In and Zn is used for the channel and resistivity of the channel layer is 1 Ωcm or higher and 1 kΩcm or lower is mentioned.

### (Mode 2 of Channel Layer: In-Ga-Zn-Sn-O System)

Next, the material of an active layer in another mode of the present invention will be described.

It is suitable that the active layer has a composition in the compositional region surrounded by the lines joining the points "a", "f", "i", and "k" on the phase diagram shown in FIG. 10 and includes Sn added thereto.

When Sn is included, it is preferable to use the following structure.

The Sn-ratio (i.e., ratio of Sn to the sum of In, Ga, Zn, and Sn) is 0.1 atomic% to 30 atomic%. The ratio is preferably 1 atomic% to 10 atomic%, and more preferably 2 atomic% to 7 atomic%.

The electrical characteristics of the oxide semiconductor including In, Ga, and Zn (particularly, the oxide semiconductor capable of realizing the normally-on TFT) are very sensitive to a change in the amount of oxygen. However, when Sn is added, the characteristics can be made insensitive to a change in oxygen partial pressure (or the amount of oxygen included in the oxide semiconductor).

The active layer may have a composition in the compositional region surrounded by lines joining the points "a", "f", and "j" on the phase diagram shown in FIG. 1 and include Sn at the following ratio. The Sn-ratio (i.e., ratio of Sn to the sum of In, Ga, Zn, and Sn) is 0.1 atomic% to 20 atomic%. The ratio is preferably 1 atomic% to 10 atomic%, and more preferably 2 atomic% to 7 atomic%.

The thickness of the oxide semiconductor (channel) in the present invention is in a range of 10 nm to 200 nm, and preferably in a range of 20 nm to 100 nm. The thickness is more preferably in a range of 30 nm to 70 nm.

### [Examples]

### (Example 1)

In this example, in order to study the chemical composition dependency of the channel layer, a combinatorial method was used. A large number of TFTs having the In-Ga-Zn-O channel layers with various compositions were fabricated on a substrate at a the same time. The compositionally graded film was used to form the library of the channel layers on the substrate. The TFTs at multiple plural positions are sequentially evaluated and compared to each other to systematically investigate the compositional dependence of the TFTs. Note that this method does not necessarily have to be used. The compositionally grade In-Ga-Zn-O film was formed using a three element oblique incidence sputtering apparatus. Three targets were located in an oblique direction relative to the substrate, so the composition of the film on the substrate was changed by differences among distances from the targets. Therefore, a thin film having a wide ternary compositional distribution can be obtained on the surface of the substrate. Table 3 shows a film formation condition of the In-Ga-Zn-O film. A predetermined compositional material source (i.e., target) may be prepared for film formation. Power applied to each of a plurality of targets may be controlled to form a thin film having a predetermined composition.

Physical properties of the formed film were evaluated by X-ray fluorescence analysis, spectral ellipsometry, X-ray diffraction, and four-point probe measurement.

The device structure of the TFTs is of the bottom-gate and top-contact type, as depicted shown in the cross-sectional view in of Figure 2. The channel layers (approximately 50 nm-thick on average) were sputter-deposited on unheated substrates in the mixtures of Ar and O₂ gases. The partial pressure of O₂ was controlled by the gas flow rate. The device has a geometry of channel width and length of the TFT channels were W = 150 um and channel length L = 10 um, respectively. The substrates are were heavily doped n-type silicon wafers coated with thermally oxidized silicon films (100nm-thick), where the n-type silicon and the oxidized silicon films worked as the gate-electrode and the gate-insulator, respectively. The source and drain electrodes of Au (40 nm) / Ti (5 nm) were formed on the channel layers by electron-beam evaporation. The films were patterned using conventional photolithography techniques. The maximum process temperature throughout the device processes was 120 degree C for the post-baking of the photo-resistin the photolithography process and no post-annealing treatment was carried out.

**Table 3 Film formation condition of In-Ga-zn-O film**

| | |
|---|---|
| Ultimate vacuum | < 1 × 10⁻⁴Pa |
| Gas pressure | 0.34-0.42 Pa |
| Gas flow rate | Ar: 50 sccm |
| | Ar + O₂ mixture (O₂: 5%): 0-16 sccm |
| RF power | Ga₂O₃ target: 60 W |
| | ZnO target: 50 W |
| | In₂O₃ target: 30 W |
| Substrate temperature | Room temperature |

The film thickness of the compositionally gradient film was measured by spectral ellipsometry, with the result that the in-plane film thickness distribution was within ±10 atomic%.

The In-Ga-Zn-O compositionally gradient film formed at an oxygen flow rate of 0.2 sccm was divided into 16 parts.

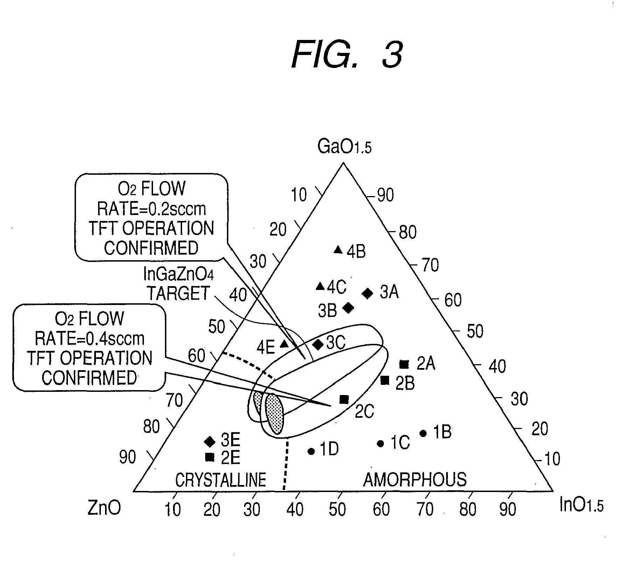

Respective addresses on the film are expressed by 1B, 1C, 1D, 2A, 2B, 2C, 2D, 2E, 3A, 3B, 3C, 3D, 3E, 4B, 4C, and 4D. Corresponding compositional ratios of In : Ga : Zn were obtained by X-ray fluorescence analysis. This result is shown in FIG. 3 as the ternary phase diagram with respect to InO_{1.5}, GaO_{1.5}, and ZnO. FIG. 10 shows the amorphous compositional region and the crystallized composition region of the In-Ga-Zn-O film which are obtained by X-ray diffraction (XRD) measurement. Although most of the formed film was an amorphous state, parts thereof had crystalline diffraction peaks observed on Zn-rich regions. To be specific, the peaks were observed in the address Nos. 2D and 3D, and 2E and 3E. It was confirmed that the observed peaks are diffraction peaks from InGaO₃(ZnO)₂ and InGaO₃(ZnO)₅. The above-mentioned result exhibits that the crystallization of the In-Ga-zn-O film becomes easier as the ZnO-compositional ratio increases.

According to spectral ellipsometry, for example, in the Ga-rich addresses 3C, 3B, and 3A, it was confirmed that the optical absorption edge was shifted to shorter wavelengths and the reflective index in the visible' region was small. Therefore, when a large amount of Ga is included, a thin film and a device on a transparent substrate show good transparency..

The sheet resistance and thickness of the In-Ga-zn-O compositionally gradient film formed at the oxygen flow rate of 0.2 sccm were measured by a four-point probe method and spectral ellipsometry, respectively, to obtain the resistivity of the film. A change in resistivity which is caused according to the In-Ga-Zn compositional ratio was confirmed.

It was found that the resistance in In-rich regions became lower and the resistance of Ga-rich regions became higher. In particular,the resistance of the film is significantly affected by the In compositional ratio. This may be caused by the fact that, in the In-rich regions, a carrier density resulting from oxygen defect is high, that an unoccupied orbit of a positive ion which becomes a carrier transmission path is particularly wide in the case of In³⁺, and thus an introduced electron carrier exhibits a high conductivity, and so on. On the other hand, in the Ga-rich regions, bond energy of Ga-O is larger than that of Zn-O or In-O. Therefore, it is supposed that the number of oxygen vacancy included in the film was reduced.

In the case of the In-Ga-Zn-O film, it was found that the compositional range exhibiting a resistance value (1 Ωcm to 1 kΩcm) suitable for a TFT active layer was relatively narrow.

Next, while the oxygen flow rate in a film formation atmosphere was changed, the resistivity of the In-Ga-Zn-O compositionally gradient film was measured. As a result, it was found that resistance of the In-Ga-Zn-O film increased with increasing oxygen flow rate. This may be caused by a reduction in the number of oxygen defects and a reduction in electron carrier density resulting therefrom. The compositional range exhibiting the resistance value suitable for the TFT active layer was sensitively changed according to the oxygen flow rate. Next, characteristics of a field-effect transistor (FET) using the In-Ga-Zn-O film as an n-type channel layer and the dependency thereof on composition were examined. As above mentioned, a large number of devices including active layers whose compositions were different from one another were formed on a single substrate. FETs formed on a 3-inch wafer were divided into 5 x 5 areas. Addresses were assigned to the areas. Characteristics of each of the FETs were evaluated. The source-drain voltage used for an FET evaluation was 6 V. The structure is shown in FIG. 2.

In the TFT characteristic evaluation, the electron mobility was obtained based on the gradient of √Id (Id: drain current) to the gate voltage (Vg) and the current ON/OFF ratio was obtained based on the ratio between the maximum Id value and the minimum Id value. The intercept on a Vg-axisin a plot of √Id to Vg was taken as the threshold voltage. The minimum value of dVg/d(log Id) was taken as the S-value (voltage value necessary to increase a current by one order of magnitude).

TFT characteristics at various positions on the substrate were evaluated to examine a change in TFT characteristic which is caused according to the In-Ga-Zn compositional ratio. As a result, it was found that the TFT characteristic was changed according to the position on the substrate, that is, the In-Ga-Zn compositional ratio.

An example of a transfer characteristic of a combinatorial FET produced at an oxygen flow rate of 0.2 sccm will be described. In an In-rich region (that is, region surrounded by lines joining the points "T", "n", "g", and "U" shown in FIG. 1), it was found that the ON current was large, the electron mobility exhibited a large value of 7 cm²(V·S)⁻¹ or higher, and the ON/OFF ratio decreased to a value of 10⁶ or.lower.

In particular, in the case where the concentration of In was high (concentration of In was 70 atomic% or higher), even when a negative gate bias is applied, a current (Id) comparable to that caused at the time of positive bias application flowed. Therefore, a transistor (switching) operation was not confirmed.

When a channel layer is formed based on the In-rich region surrounded by the lines joining the points "T", "n", "g", and "U" shown in FIG. 1, a transistor whose on-current is large and threshold is negative can be realized.

On the other hand, in a Ga-rich region (in a range in which the concentration of Ga is 40 atomic% or higher and 50 atomic% or lower), the current ON/OFF ratio was 10⁶ or higher, so a relatively preferable transistor operation was confirmed. The threshold voltage was of a positive value, with the result that a "normally off characteristic" in which a current does not flow at the time when the gate voltage is not applied was obtained. However, in this example, although depending on the amount of oxygen, the drain current in a case of an ON state was small and only the electron mobility of about 1 to 2 cm²(V·S)⁻¹ was obtained. That is, when a channel layer is formed based on the Ga-rich region surrounded by the lines joining the points "Y", "h", "i", and "k" shown in FIG. 1, a transistor whose off-current is small and threshold is positive can be realized.

The region in which the FET characteristic with the maximum mobility was obtained is the Zn-rich region (In-Ga-Zn compositional ratios are approximately 25 atomic%, 30 atomic%, and 45 atomic%). The electron mobility, current ON/OFF ratio, threshold, and S-value were 7.9 cm² (V·S)⁻¹, 3 × 10⁷, 2.5 V, and 1.12 V/decade, respectively. From a comparison with a result obtained by X-ray diffraction of the In-Ga-Zn-O film, it was confirmed that the region exhibiting preferable TFT characteristics is the amorphous region.

It was found that the compositional range exhibiting excellent characteristics on all FET characteristics including mobility, ON/OFF ratio, and normally-off characteristic was relatively narrow.

It is confirmed that a TFT operation is performed in the case where a resistivity value is several Ωcm to several 1000 Ωcm and it is found that the correlation between the FET characteristic and the resistivity is large.

Next, a combinatorial FET was produced at an oxygen flow rate of 0.4 sccm and the oxygen partial pressure dependence during the film formation of the In-Ga-Zn-O film was examined. Both the current ON/OFF ratio and the threshold voltage increased with increasing oxygen flow rate. As compared with the case where the oxygen flow rate was 0.2 sccm, the resistance of the In-Ga-Zn-O film becomes higher, so an FET operation region was shifted to the In-rich region. As a result, a TFT device having a large mobility could be obtained at the In-rich compositions. In the case where the oxygen flow rate was 0.4 sccm, a region in which the FET characteristic with the maximum mobility was obtained was the Zn-rich region. The In-Ga-Zn compositional ratios are 28 atomic%, 27 atomic%, and 45 atomic%. The compositional ratio of In is larger than that in the case where the oxygen flow rate was 0.2 sccm. A high electron mobility of 12.2 cm²(V·S)⁻¹ was thus obtained. At this time, the current ON/OFF ratio, the threshold, and the S-value were 1 x 10⁻⁷, 3 V, and 1.1 V/decade, respectively. These values are almost same as those in the case the oxygen flow rate was 0.2 sccm.

The above-mentioned study result was intensively analyzed by the inventors of the present invention. As a result, when the In-Ga-Zn-O film was applied to the TFT active layer, it was found that preferable characteristics were exhibited in the case where the resistivity of the thin film is particularly set to several Ωcm to kΩcm. In particular, in order to produce a transistor having a small OFF current, it is desirable that the resistivity be set to 10 Ωcm to kΩcm.

In the case of the In-Ga-Zn-O film, it was found that the compositional range exhibiting the resistivity (several Ωcm to several 1000 Ωcm) suitable for the TFT active layer was relatively narrow. The compositional range exhibiting a resistance value suitable for the TFT active layer was sensitively changed according to the oxygen flow rate. Therefore, it was found that the influence of the amount of oxygen on the resistance' value was large.

FIG. 3 shows TFT operation regions summarized on a ternary phase diagram of In, Ga, and Zn based on the above-mentioned results. The TFT operation regions is the compositional region, where the transistors show switching operation successfully.

Next, the oxygen flow rate was further increased and combinatorial TETs were produced at oxygen flow rates of 0.6 sccm and 0.8 sccm. At this time, the resistivity of the In-Ga-Zn-O film in the Ga-rich region became too high. Therefore, even in the case where the positive gate bias was applied, only the same current as that in the case where the negative bias is applied flowed, so the transistor operation could not be confirmed. On the other hand, in the Ga-less region, the In-Ga-Zn-O film exhibited the resistivity suitable for the TFT active layer because a high resistance was realized. Thus, as compared with the case where the oxygen flow rate was 0.4 sccm, it was found that the TET operation region was shifted to the Ga-less region. At this time, a TFT device whose field-effect mobility is large and S-value is small could be obtained as compared with the case where the oxygen flow rate was 0.4 sccm. To be specific, in the compositional region in which the compositional ratio of Ga is 15 atomic% or lower, the field effect mobility was 12 cm²/Vs or higher and the S-value was 1 V/decade or lower.

Result obtained by TFT evaluation in this example are briefly summarized below.

The following can be said with respect the composition dependence.

In the In-rich region (region surrounded by the lines joining the points "n", "g", "U" and "T" shown in FIG. 1), the field-effect mobility is large and the hysteresis is small.

In the Ga-rich region (region surrounded by the lines joining the points "Y", "h", "i" and "k"), the OFF current is small, the current ON/OFF ratio is large, and the threshold is large. The optical stability and the optical transparency are preferable.

In the Zn-rich region (region surrounded by the lines joining the points "S", "n", "k", and "V"), each of the mobility and the current ON/OFF ratio is large and the S-value is relatively small.

The following can be said with respect the oxygen partial pressure dependence.

When the oxygen partial pressure increases, the TFT operation region is shifted to the In-rich region, so it is advantageous to realize large mobility, device

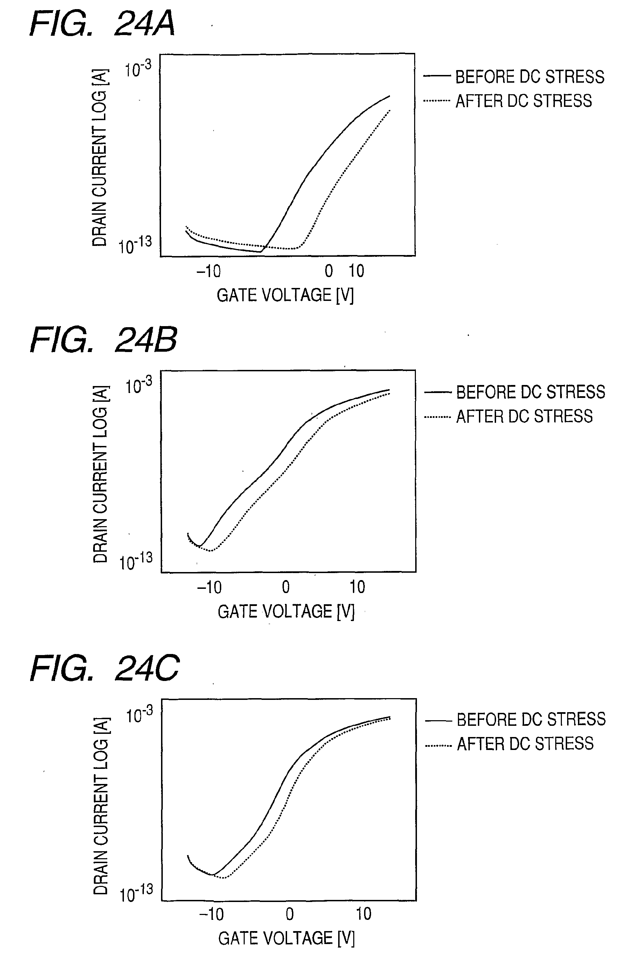

Next, a DC bias stress test was performed on the TFT produced in this example. To be specific, for 400 seconds, a DC voltage stress of 12 V was applied to the gate electrode and a DC voltage stress of 12 V,was applied between the source electrode and the drain electrode. Changes in TFT characteristics were evaluated. As a result, it was found that variations in characteristics which were caused by the DC stress were large in the Ga-rich region and particularly the threshold was shifted to the pulse side by approximately 3 V. On the other hand, changes in characteristics were hardly observed in the In-rich region in which the field-effect mobility was high. Therefore, it was found that the TFT was insensitive to the DC stress. FIGS. 24A, 24B, and 24C show transfer characteristics obtained before and after the application of the DC stress in typical compositions. In FIGS. 24A, 24B, and 24C, the In-Ga-Zn compositional ratios are 27 : 46 : 27, 1 : 1 : 1, and 35 : 10 : 55, respectively. From those results, a transistor having large field-effect mobility and good operation stability can be realized when the compositional ratio of Ga to the sum of metal elements is made smaller than a conventional compositional ratio of In:Ga:Zn=1:1:1.

Table 4 shows a summary of field-effect mobilities, S-values, and threshold shifts caused by the DC stress, which are associated with respective metal compositional ratios in the TFTs obtained in this example. In Table 4, "-" displayed on a section indicating the mobility or the like exhibits that a preferable TFT operation was not obtained at the corresponding compositional ratio because of a small current ON/OFF ratio.

**Table 4**

| In : Ga : Zn [Atom number ratio] | Field-effect mobility [cm²/Vs] | S-value [V/decade] | Threshold shift [V] |
|---|---|---|---|
| 27:46:27 | 1.8 | 1.2 | 4.5 |
| 1:1:1 | 5 | 1.2 | 2.6 |
| 5:30:65 | - | - | 2.5 |
| 10:30:60 | 7 | 1.15 | 2.4 |
| 25:30:45 | 7.9 | 1.12 | 2.1 |
| 35:30:35 | 8 | 1.15 | 1.9 |
| 60:30:10 | 8.2 | 1.2 | 1.1 |
| 65:30:5 | - | - | - |
| 28:27:45 | 12.2 | 1.1 | 1.5 |
| 20:15:65 | - | - | - |
| 22.5:15:62.5 | 12 | 0.85 | 0.9 |
| 34:15:51 | 12.5 | 0.8 | 0.8 |
| 42.5:15:42.5 | 13 | 0.9 | 0.8 |
| 57.5:27.5:15 | 13 | 1 | 0.6 |
| 60:15:25 | - | - | - |
| 20:10:70 | - | - | - |
| 30:10:60 | 13.5 | 0.7 | 0.8 |
| 35:10:55 | 13.6 | 0.6 | 0.7 |
| 50:10:40 | 13.5 | 0.8 | 0.5 |
| 60:10:30 | - | - | - |

An oxide semiconductor made of a ternary material of In-Ga-Zn-O system has the degree of freedom of material design, since physical properties are significantly adjusted according to the composition. Therefore, for any purpose, the compositioncan be tuned. As described above, the In-Ga-Zn compositional ratio can be set according to any purpose.

### (Example 2)

As described in Example 1, it is found that There is the correlation between the resistivity of the In-Ga-Zn-O film and the TFT characteristic. The TFT operation is performed in the condition where the resistivity value is several Ωcm to several 1000 Ωcm. However, the In-Ga-Zn compositional ratio range exhibiting the above-mentioned resistance value is narrow. In particular, the compositional ratio range exhibiting preferable TFT characteristics is narrow.
The In-Ga-Zn compositional ratio exhibiting a preferable resistance is significantly changed according to the oxygen flow rate in a film formation atmosphere of the In-Ga-Zn-O film.

Example 2 shows an example in which Sn is added to an amorphous oxide semiconductor of In-Ga-Zn-O. Therefore, the resistance value can be controlled and compositional ratio margin for TFT operation can be widened.

A compositionally gradient film of In-Ga-Zn-O:Sn was formed using a three element oblique incidence sputtering apparatus as in Example 1. Table 5 shows a film formation condition of the In-Ga-Zn-O:Sn film. The addition of Sn to the film was performed using an ITO target (SnO₂ : 4.6 atomic%) made of a sintered material of In₂O₃ and SnO₂ as an In target. Physical properties of the formed film were evaluated by X-ray fluorescence analysis, spectral ellipsometry, X-ray diffraction, and four-point probe measurement. A prototype of a bottom-gate top-contact TFT using an In-Ga-Zn-O:Sn compositionally gradient film as an n-type channel layer was produced and operating characteristics thereof were evaluated at a room temperature.

**Table 5 Film formation condition of In-Ga-Zn-O:Sn film**

| | |
|---|---|
| Ultimate vacuum | < 1 × 10⁻⁴ Pa |
| Gas pressure | 0.34-0.42 Pa |
| Gas flow rate | Ar:50 sccm |
| | Ar + O₂ mixture (O₂ : 5%): 4-12 sccm |
| RF power | Ga₂O₃ target: 60 W |
| | ZnO target: 50 W |
| | ITO target: 30 W |
| Substrate temperature | Room temperature |

According to spectral ellipsometry measurement, it was confirmed that the in-plane film thickness distribution of the film was within ±10 atomic%.

A substrate on which the In-Ga-Zn-O:Sn film was formed was divided into 16 parts. Compositional ratios of In : Ga : Zn which are associated with respective addresses were obtained by X-ray fluorescence analysis. The compositional ratios among In, Ga, and Zn are equal to those in Example 1. Although the compositional ratio of Sn could not be measured because of the low concentration, it may be proportional to the concentration of In. At this time, the oxygen flow rate was 0.2 sccm.

The sheet resistance and thickness of the In-Ga-Zn-O:Sn compositionally gradient film formed at an oxygen flow rate of 0.4 sccm were measured by a four-point probe method and spectral ellipsometry, respectively, to obtain the resistivity of the film. A change in resistivity which is caused according to the In-Ga-Zn compositional ratio was confirmed as in the case where Sn was not added in Example 1. It was found that resistance of the In-rich regions became lower and resistance of the Ga-rich regions became higher. As described in Example 1, it was confirmed that the TFT shows switching operation successfully was exhibited in the TFT using the In-Ga-Zn-O film as the n-type channel layer in the case where the resistivity of the In-Ga-Zn-O film was several Ωcm to several 1000 Ωcm. In the case of the In-Ga-Zn-O film to which Sn was not added, the above-mentioned resistance value was exhibited only in a considerably narrow ternary compositional region of In01.5-Ga01.5-ZnO. However, when Sn was added, it was found that there was the tendency to widen the compositional range exhibiting the resistivity preferable to produce a TFT.

Next, while the oxygen flow rate in the film formation atmosphere was changed, the resistivity of the In-Ga-Zn-O:Sn compositionally gradient film was measured. As a result, it was found that the resistance of the In-Ga-Zn-O film increased with increasing oxygen flow rate. This may be caused by a reduction in the number of oxygen defects and a reduction in electron carrier density resulting therefrom. It was confirmed that the compositional range exhibiting the resistance value suitable for the TFT active layer was changed according to the oxygen flow rate. It was found that the change became smaller than that in the case where Sn is not added.

As is apparent from the above-mentioned results, it was found that the addition of Sn to the In-Ga-Zn-O film brought about the effects to (1) widen the In-Ga-Zn compositional ratio range exhibiting the resistance value suitable for the TFT active layer and (2) widen the conditional range with respect to the oxygen flow rate in the film formation atmosphere.

Next, in order to examine characteristics and the compositional dependence of a field-effect transistor (FET) using the In-Ga-Zn-O:Sn film as an n-type channel layer, a prototype of the FET was produced. The structure of the FET and evaluation method thereof were identical to those in Example 1.

Changes in FET characteristics according to the In-Ga-Zn compositional ratio were observed as in the case of the first embodiment. It was confirmed that the same tendency was exhibited in both cases. It was found that the In-Ga-Zn compositional region exhibiting the TFT operation widened in the case of the In-Ga-Zn-O film to which Sn was added. In particular, the FET operation range widened in the In-rich region, with the result that a TFT having a larger mobility was obtained as compared with the case where Sn is not added.

In Example 1, a high carrier mobility was obtained in the In-rich region. On the other hand, the OFF current was large because it is difficult to reduce the residual carrier density. The transistor operation was not exhibited in some cases.

However, in this example, the amount of carrier which is caused by oxygen defect was suppressed by the addition of Sn. Therefore, it can be expected that the TFT operation can be realized in a wide compositional range. The region in which the FET characteristic with the maximum mobility was obtained was the Zn-rich region in which the In-Ga-Zn compositional ratios were 28 atomic%, 27 atomic%, and 45 atomic% (In-Ga-Zn-O to which Sn was added: this example). In Example 1, the characteristic with the large mobility was obtained at the compositional ratios of 25 atomic%, 30 atomic%, and 45 atomic% (In-Ga-Zn-O to which Sn was not added: Example 1). As compared with this, a larger mobility of 10.1 cm²(V·S)⁻¹ was obtained at a composition in which the compositional ratio of In was increased by the addition of Sn. At this time, the current ON/OFF ratio, threshold, and S-value were 3 × 10⁷, 0.5 V, and 0.83 V/decade, respectively, and thus the same values as those in the case where Sn was not added were obtained.

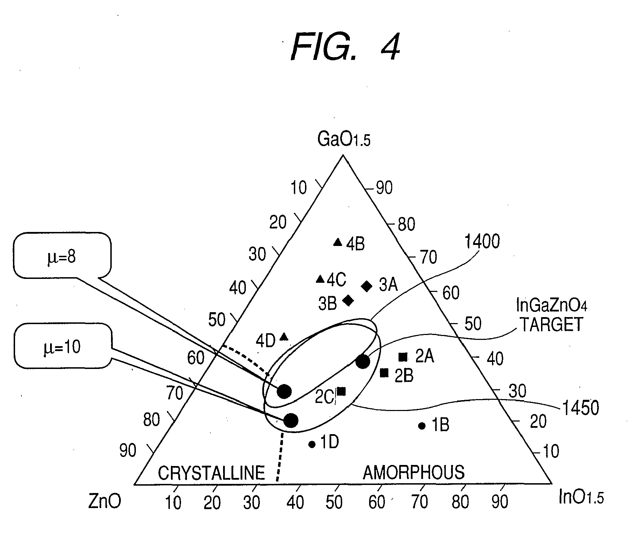

FIG. 4 shows TFT operation regions summarized on the ternary phase diagram of In, Ga, and Zn based on the above-mentioned results. In this figure, reference numeral 1400 denotes a compositional region suitable for a TFT operation in the case where Sn is not included, and 1450 denotes that in the case where Sn is added.

Thus, there is the effect that the addition of Sn to the In-Ga-Zn-O film widens the In : Ga : Zn compositional ratio range suitable for the TFT active layer.

It was found that there is the effect that the addition of Sn widens a conditional range with respect to the oxygen flow rate in the film formation atmosphere.

A prototype of a TFT using the In-Ga-Zn-O film as an active layer was actually produced. Then, in the case of the In-Ga-Zn-O film to which Sn was added, it was found that the compositional range exhibiting the TFT operation widened. In particular, the TFT operation range widened in the In-rich region. As a result, it was found that a TFT device having a large mobility is obtained as compared with the case where Sn is not added.

As described above, in this example, the In-Ga-Zn-O film to which Sn was added was applied to the active layer of the TFT. This material enables to reduce variations in TFT characteristics, which are caused according to the variation of the In-Ga-Zn compositional ratio and the amount of oxygen. Therefore, a variation between devices and a variation between lots are reduced. That is, when the In-Ga-Zn-O film to which Sn is added is applied to the active layer of the TFT, a TFT array excellent in uniformity and reproducibility can be realized.

### (Example 3)

In Example 3, the In-Zn compositional ratio dependence of an active layer made of an In-Zn-O oxide semiconductor was studied as in Example 1.

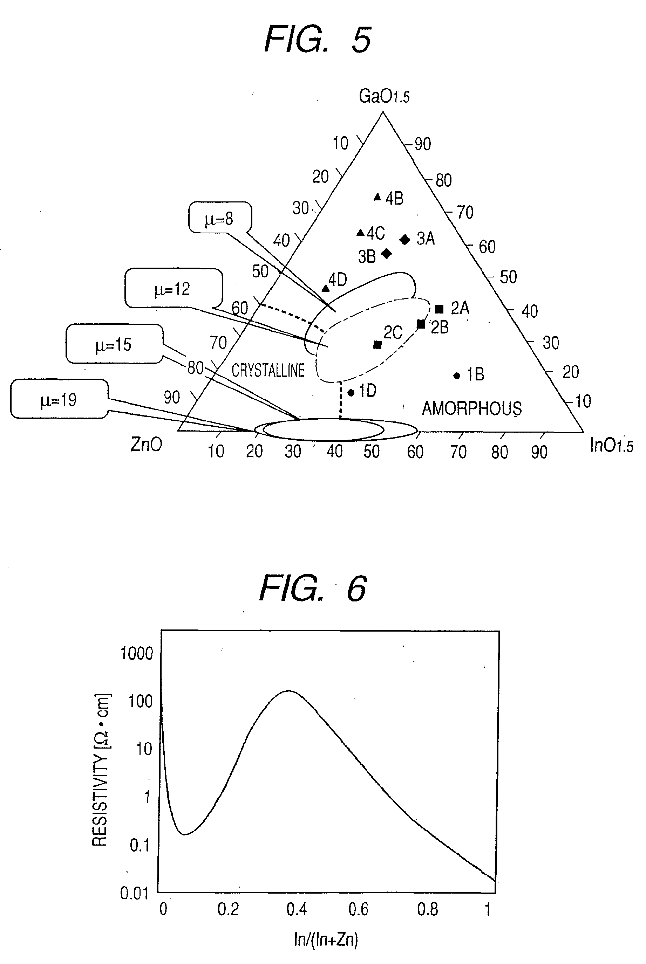

A large mobility of 15 cm²(V·S)⁻¹ was obtained at a compositional ratio in which In is 40 atomic% and Zn is 60 atomic% and at ratios therearound. The S-value and ON/OFF ration were also preferable. When X-ray diffraction was performed at this compositional ratio, a diffraction peak exhibiting the presence of crystal was not observed. The TFT device was analyzed by using a cross-section transmission electron microscope (TEM). As a result, it was confirmed that the In-Zn-O oxide semiconductor having the above-mentioned compositional ratio was amorphous. FIG. 5 shows a compositional region in which relatively preferable TFT characteristics are obtained by combining results of Example 3 and the results of Example 1.

Example 3 shows an example in which an oxide semiconductor including In and Zn as main metal ingredients is used for a TFT active layer. A TFT device having excellent characteristics can be obtained.

An In-Zn-O film was formed using a three element oblique incidence sputtering apparatus as in Example 1. In this example, binary film formation was performed using two targets of In₂O₃ and ZnO. Film thickness gradient was also formed in the direction orthogonal to the compositional gradient. Therefore, the film thickness dependence and the composition dependence can be evaluated using a single substrate. The following table shows a film formation condition of the In-Zn-O film.

**Table 6**

| | |
|---|---|
| Ultimate vacuum | < 1 × 10⁻⁴ Pa |
| Gas pressure | 0.34-0.42 Pa |
| Gas flow rate | Ar: 50 sccm |
| | Ar + O₂ mixture (O₂: 5%): 14-16 sccm |
| RF power RF power | ZnO target: 45-46 W |
| | In₂O₃ target: 30 W |
| Substrate temperature | Room temperature |
| Film formation time | Single film: 30 minutes, TFT: 5-6 minutes |
| Substrate | Single film:4-inch silicon with thermal oxide semiconductor film TFT:3-inch silicon with thermal oxide semiconductor film |

Physical properties of the formed film were evaluated by X-ray fluorescence analysis, spectral ellipsometry, X-ray diffraction, and four-point probe measurement. A prototype of a bottom-gate top-contact TFT using an In-Zn-O compositionally gradient film as an n-type channel layer was produced and TFT characteristics thereof were evaluated at a room temperature.

FIG. 6 shows resistivities of the In-Zn-O film which are associated with different In-Zn compositional ratios. As in the case of Example 1, a change in resistivity according to a composition was confirmed.

When attention is given to a compositional region in which the ratio of In to the sum of metals is 40 atomic% or higher, it is found that resistance of the In-rich regions becomes lower and resistance of the In-rich regions becomes higher. This may be caused by the fact that, in the In-rich regions, for example, carrier density resulting from oxygen defect is high, an unoccupied orbit of a positive ion which becomes a carrier transmission path is particularly wide in the case of In³⁺, and an introduced electron carrier exhibits a high conductivity. On the other hand, in a compositional region in which the ratio of In to the sum of metals is 40 atomic% or lower, it is found that the resistivity becomes minimum at a composition in which the ratio of In is several atomic%. This may be caused by the fact that In³⁺ substitutes in the Zn²⁺ site of a crystallized IZO film to generate carriers. It was actually determined by XRD measurement that the In-Zn-O films in which the ratio of In is 35 atomic% or lower were crystallized. It was found that the compositional range exhibiting the resistivity (1 Ωcm to 1 kΩcm) suitable for the TFT active layer was 20 atomic% to 80 atomic% in terms of In-ratio.

Next, a TFT using the In-Zn-O film as an n-type channel layer was produced and TFT characteristics and the composition dependence thereof were examined. The structure of the TFT and evaluation method thereof were identical to those in Example 1.

When the oxygen partial pressure during the film formation of the In-Zn-O film was adjusted, the TFT operation was possible in a wide In-Zn compositional range. In particular, it was confirmed that the reproducibility of the TFT operation was preferable in an In-ratio range of 30 atomic% to 60 atomic%.

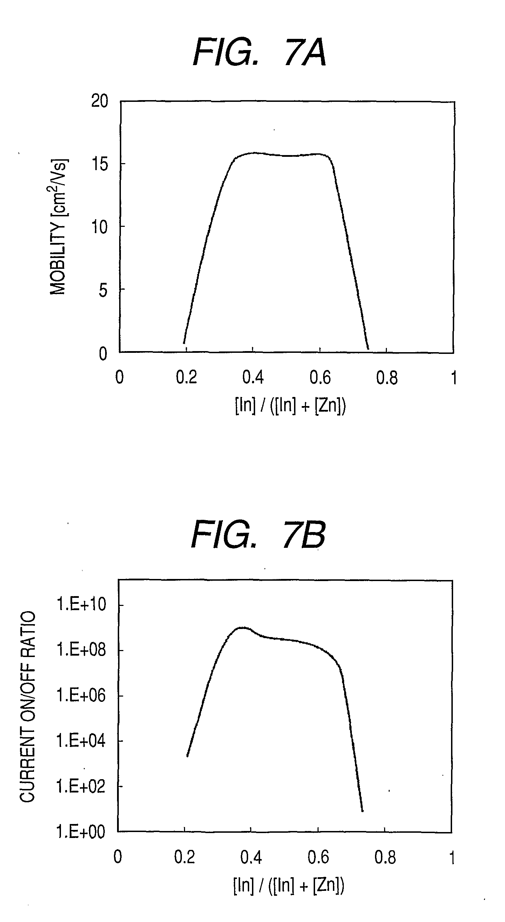

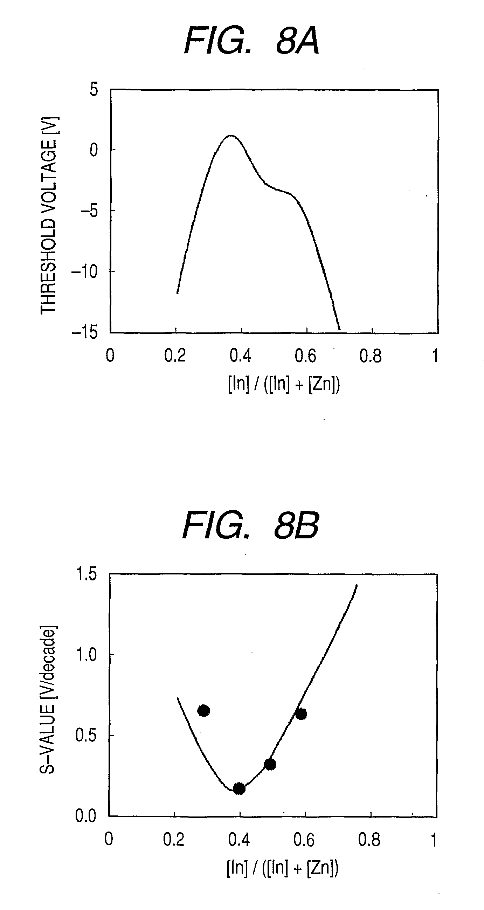

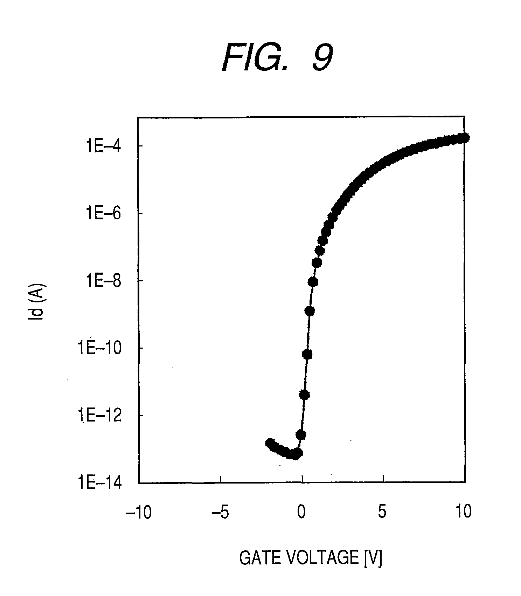

FIGS. 7 and 8 are plots of TFT characteristics based on different In-Zn compositional ratios. At this time, the In ratio range in which the TFT operation is confirmed was 30 atomic% to 60 atomic%. In a compositional range in which the In-ratio is 30 atomic% or higher, the mobility constantly exhibits a high value of 15 cm²/Vs or higher. On the other hand, it was confirmed that the current ON/OFF ratio, the threshold voltage, and the S-value were changed corresponding to compositions, and thus it was found that each thereof had a peak at the region of 40 atomic% in terms of In-ratio. FIG. 9 shows a transfer characteristic of the TFT at a In-ratio of 40 atomic%. The mobility, the current ON/OFF ratio, the S-value, and the threshold voltage were 16.5 cm²/Vs, 10⁹, 0.16 V/decade, and 2 V, respectively. Therefore, it is possible to obtain a TFT device having particularly excellent characteristics among In-Ga-Zn-O TFTs.

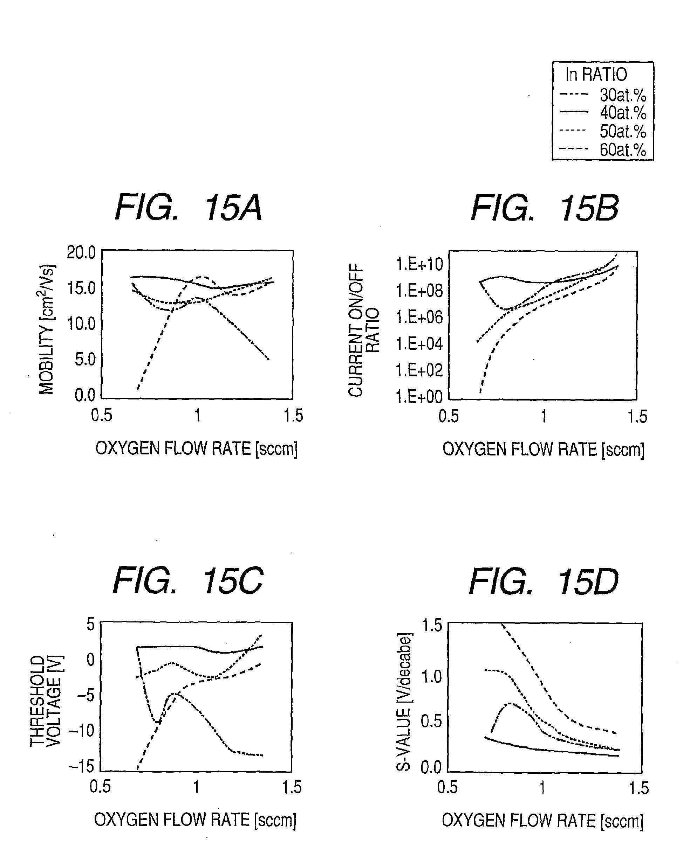

Next, changes in TFT characteristics which are caused while the oxygen flow rate in the In-Zn-O film formation atmosphere is changed were examined. The results are shown in FIGS. 15A, 15B, 15C, and 15D , where the data of the In-ratio is 30 atomic%, 50 atomic%, and 60 atomic% are plotted. It was confirmed that the TFT characteristics of the mobility, the ON/OFF ratio, the S-value, and the threshold voltage largely depend on the oxygen flow rate. In particular, the S-value was preferable in a range in which the In-ratio is not less than 35 atomic% and not more than 55 atomic%, more preferable in an In-ratio range of 40 atomic% to 50 atomic%.

As above mentioned, when the channel layer was formed under the condition of oxygen flow rate of 0.8 sccm, most excellent characteristics was obtained in the compositional ratio in which the In-ratio is 40 atomic%., Even when the oxygen flow rate was changed, the excellent characteristics were exhibited in the same compositional ratio. Therefore, it was found that parameters including the field mobility take substantially constant values in the figure 15. As described in Example 1, the In-Ga-Zn-O oxide semiconductor TFT had such a problem that the In-Ga-Zn compositional ratio exhibiting the preferable characteristics is significantly changed by a slight change in oxygen flow rate in the film formation atmosphere. This example shows that the In-Zn-O film is used as the TFT active layer having the above-mentioned compositional ratio to widen a process margin and reduce a variation between devices and a variation between lots.

The composition in which the In-ratio is 40 atomic%, exhibiting the most excellent characteristics, is identical to the composition in which there is a peak of the resistivity of the In-Zn-O film. Therefore, it was found that the correlation between the TFT characteristic and the resistivity of the active layer is large even in the case of In-Zn-O system.

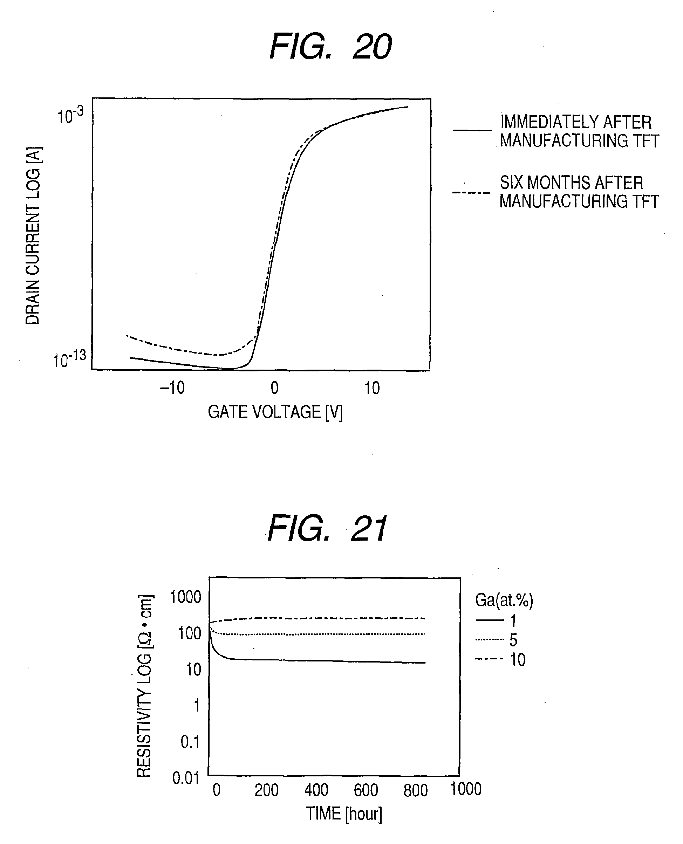

Next, it was cleared that the value of the resistivity of the In-Zn-O film is changed in a condition in which the film is merely left in the air. When the In-Zn-O film is left in the air, for example, for half a year, the resistivity was reduced by up to approximately three orders of magnitude in some cases. However, it was found that the degree of temporal change in resistivity was changed according to the In-Zn composition, and it was cleared that a temporal change is hardly caused at some compositions. FIG. 19 shows temporal changes in resistivity of the In-Zn-O film at different In-Zn compositions. Here, of special note is that, although the resistivity of the In-Zn-O film having the In-ratio of 40 atomic% exhibiting the excellent TFT characteristics is slightly reduced while it is left in the air for 24 hours, a value of several 10 Ω·cm was stably obtained after that. Further a TFT was produced by using the In-Zn-O film having the composition, and TFT characteristics which were obtained immediately after it is produced and after it is left in the air for half a year were evaluated for comparison. This result is shown in FIG. 20. As a result, any difference between the characteristics of both the TFTs is hardly observed. Therefore, when the In-Zn-O film having the composition in which the In-ratio is 40 atomic% is applied to the active layer of the TFT, it is found that a relatively stable TFT can be realized.

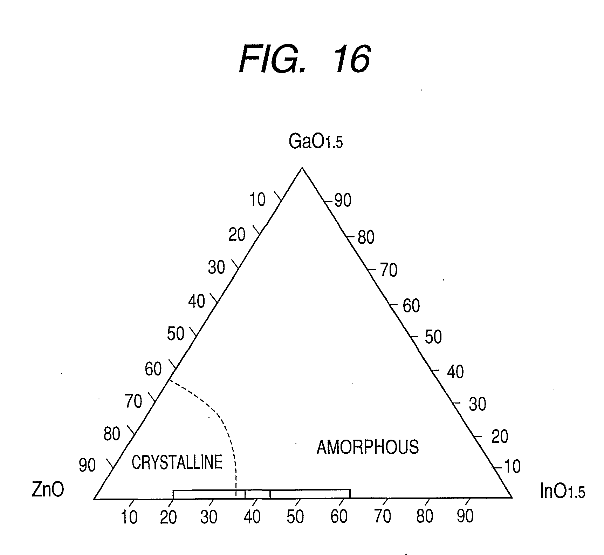

As described above, in this example, the In-Zn-O film is used as the active layer. Therefore, it is possible to obtain a TFT having excellent characteristics including the mobility, the current ON/OFF ratio, the S-value, and the threshold voltage. In particular, when the atom number ratio of In : Zn is 40 : 60, a TFT having a wide process margin and small temporal change can be realized. FIG. 16 shows compositional regions in which preferable TFT characteristic are obtained, which are summarized on the ternary phase diagram of In, Ga, and Zn, based on the result obtained in this example. It is more preferable that the ratio of Ga be within 5 atomic% in view of the S-value as described above.

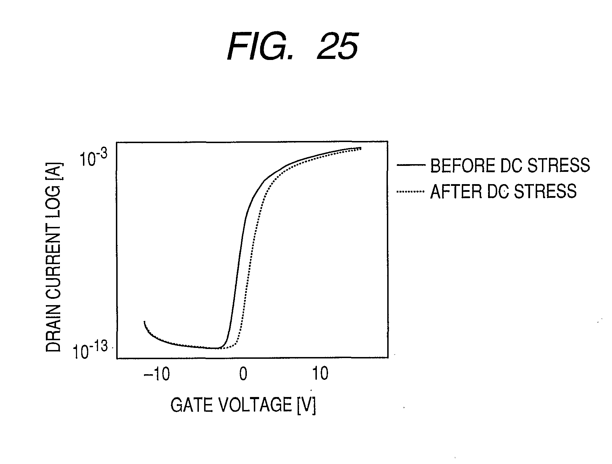

Next, the TFT which was left in the air for half a year was subjected to a DC bias stress test. To be specific, for 400 seconds, a DC voltage stress of 12 V was applied to the gate electrode and a DC voltage stress of 12 V was applied between the source electrode and the drain electrode. Changes in TFT characteristics were thus evaluated. As a result, it was found that variations in characteristics which are caused by the DC stress were much smaller than those in the case of the conventional In-Ga-Zn-O film. In addition, even in the case of the composition in which the atom number ratio of In : Zn is 40 : 60, exhibiting the excellent TFT characteristics, the threshold shift was approximately 0.7 V. Therefore, it was found that a preferable DC stress resistance was obtained. FIG. 25 shows transfer characteristics obtained before and after the DC stress at the above-mentioned composition.

Table 7 shows a summary of field-effect mobilities, S-values, and threshold shifts caused by the DC stress which are associated with respective metal compositional ratios in the TFTs obtained in this example. In Table 7, "-" displayed on sections indicating the mobility and the S-value exhibits that a preferable switching operation was not obtained at the corresponding compositional ratio because of a small current ON/OFF ratio.

**Table 7**

| | Immediately after TFT is produced | | After TFT is left in air for half a year | | |
|---|---|---|---|---|---|
| In:Ga:Zn [Atom number ratio] | Field-effect mobility [cm²/Vs] | S-value [V/decade] | Field-effect mobility [cm²/Vs] | S-value [V/decade] | Threshold shift [V] |
| 20:0:80 | - | - | - | - | - |
| 30:0:70 | 13 | 0.7 | - | - | - |
| 35:0:65 | 16 | 0.2 | 16.5 | 0.22 | 0.7 |
| 40:0:60 | 16.5 | 0.16 | 17 | 0.17 | 0.7 |
| 50:0:50 | 16.5 | 0.3 | 17 | 0.34 | 0.5 |
| 55:0:45 | 17 | 0.4 | 17 | 0.46 | 0.4 |
| 60:0:40 | 17 | 0.6 | - | - | - |
| 70:0:30 | - | - | - | - | - |

### (Example 4)

As described in Example 3, the characteristics of the TFT using the oxide semiconductor for the active layer are changed depending on composition thereof in a condition in which the TFT is merely left in the air. So, it is expected to improve temporal stability. Even in the case of the In-Zn-O film having the composition in which the atom number ratio of In : Zn is 40 : 60, there is a slight temporal variation in resistivity. Therefore, it is desirable to further improve the temporal stability.

Example 4 shows an example in which an In-Ga-Zn-O oxide semiconductor having a composition in which the ratio of Ga to the sum of metals is 1 atomic% to 10 atomic%, was used for the TFT active layer. Therefore, a TFT having excellent temporal stability and preferable characteristics can be obtained. When the semiconductor is used for the TFT active layer, a variation between devices and a variation between lots are reduced, with the result that a TFT array excellent in reproducibility can be realized.

An In-Ga-Zn-O film was formed using a three element oblique incidence sputtering apparatus as in Example 1. The following table shows a film formation condition.

**Table 8**

| | |
|---|---|
| Ultimate vacuum | < 1 × 10⁻⁴ Pa |
| Gas pressure | 0.34-0.42 Pa |
| Gas flow rate | Ar: 50 sccm |
| | ArO₂ mixture (O₂: 5%) : 10-20 sccm |
| RF power | InGaZnO₄ target: 30-40 W |
| | ZnO target: 45-50 W |
| | In₂O₃ target : 30 W |
| Substrate temperature | Room temperature |
| Film formation time | Single film: 30 minutes, TFT: 3-5 minutes |
| Substrate | Single film: 4-inch silicon with thermal oxide semiconductor film |
| | TFT: 3-inch silicon with thermal oxide semiconductor film |

In this example, the oxide films were formed by using three targets of In₂O₃, ZnO, and InGaZnO₄.
Therefore, it is possible to obtain an In-Ga-Zn-O thin film with high film thickness uniformity, which has a compositional distribution in which the Ga-ratio is 1 atomic% to 10 atomic% on a single substrate. At this time, a Ga concentration distribution is formed in a direction orthogonal to an In-Zn compositional gradient. Physical properties of the formed film were evaluated by X-ray fluorescence analysis, spectral ellipsometry, X-ray diffraction, and four-point probe measurement. A prototype of a bottom-gate top-contact TFT using an In-Ga-Zn-O compositionally gradient film as an n-type channel layer was produced, and TFT characteristics thereof were evaluated at a room temperature.

The resistivity of the In-Ga-Zn-O film was measured. Comparison was made while the Ga-ratio was fixed. As a result, it was found that the tendency of behavior of the resistivity which is caused according to the In-Zn compositional ratio was identical to that in the case of the In-Zn-O film (Ga less film). In a compositional region in which the In-atom number ratio is 40 atomic% or higher, the resistance value was slightly higher than that in the case of the In-Zn-O film. As a result, it was found that the compositional range exhibiting the resistivity (1 Ωcm to 1 kΩcm) suitable for the TFT active layer widened.

Next, a TFT using the In-Ga-Zn-O film having the compositional distribution in which the Ga-ratio is 1 atomic% to 10 atomic% as an n-type channel layer was produced, and the TFT characteristics and the composition dependence thereof were examined. The structure of the TFT and evaluation method thereof were identical to those in Example 1.

Changes in TFT characteristics which are caused in accordance with the In-Ga-Zn compositional ratio were observed. When the Ga ratio was maintained to a predetermined value for comparison, it was confirmed that the same tendency as that in the TFT using the In-Zn-O film was exhibited. In particular, the TFT operation was performed with high reproducibility in a region in which the atomic ratio of In : Zn is 20 : 80 to 70 : 30. In a compositional range in which the In-ratio is 30 atomic% or higher, the mobility constantly exhibited a high value of 13 cm²/Vs or higher. On the other hand, it was confirmed that the current ON/OFF ratio, the threshold voltage, and the S-value were changed corresponding to compositions, and thus it was found that each thereof had a peak at an In-Zn atomic ratio of 40 : 60 (In : Gas : Zn = 38 : 5 : 57). At this time, the mobility of the TFT, the current ON/OFF ratio thereof, the S-value thereof, and the threshold voltage thereof were 15 cm²/Vs, 109, 0.2 V/decade, and 3 V, respectively. Therefore, it is possible to obtain a TFT device having excellent characteristics.

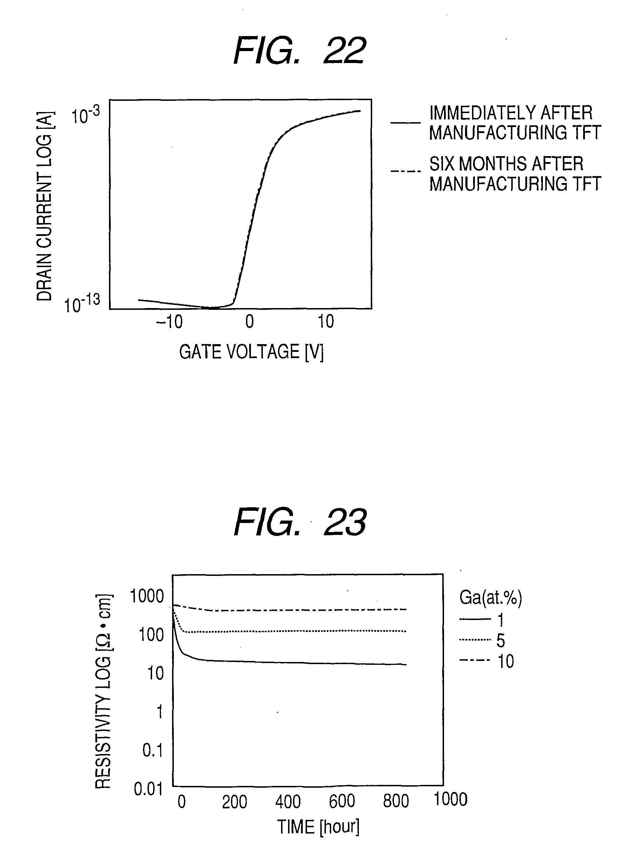

Next, in order to examine the temporal stability of the In-Ga-Zn-O film, the thin film is left in the air and a temporal change in resistivity was measured. As a result, a temporal change in resistivity which is caused depending on the amount of Ga was observed. Therefore, it was found that the resistivity of an oxide semiconductor film whose Ga compositional ratio is 5 atomic% or higher was hardly changed between the state immediately after the film was formed and the state after the film was left in the air for half a year, at different In-Zn ratios. This exhibits that the temporal stability is improved by the addition of an adequate amount of Ga to the film. FIG. 21 shows temporal changes in resistivities at an In-Zn atomic weight ratio of 40 : 60. TFTs were actually produced using an In-Ga-Zn-O film whose atomic ratio of In : Ga : Zn is 38 : 5 : 57, and TFT characteristics thereof obtained immediately after the TFT was produced and after the TFT was left in the air for half a year were evaluated for comparison. As a result, a difference between the characteristics of both the TFTs was hardly observed. Therefore, it was confirmed that the excellent characteristics were always stably exhibited. FIG. 22 shows results obtained by evaluation of the above-mentioned TFT characteristics.

Then, an In-Ga-Zn-O film having a high resistivity, exhibiting a so-called "normally-off characteristic" in which a current does not flow at the time when the gate voltage is not applied, was produced to evaluate the temporal stability thereof. This result is shown in FIG. 23. As in the above-mentioned case, the temporal change in resistivity which is caused depending on the amount of Ga was observed. However, it was found that the resistivity of the oxide semiconductor film whose Ga compositional ratio is 5 atomic% or higher was reduced to approximately 1/3 of the initial value thereof after the film was left in the air for 24 hours. On the other hand, a change in resistivity of a film whose Ga compositional ratio is 10 atomic% was hardly observed. As described above, in this example, the In-Ga-Zn-O film having the composition in which the Ga-ratio is 1 atomic% to 10 atomic% is applied to the TFT active layer. Therefore, it is possible to obtain TFT devices in which a variation between the devices and a variation between lots are small and the characteristics are preferable. In particular, when the In-Ga-Zn-O film having the composition in which the atom number ratio of In : Ga : Zn is 38 : 5 : 57 is applied to the TFT active layer, a TFT excellent in temporal stability and characteristics can be realized.

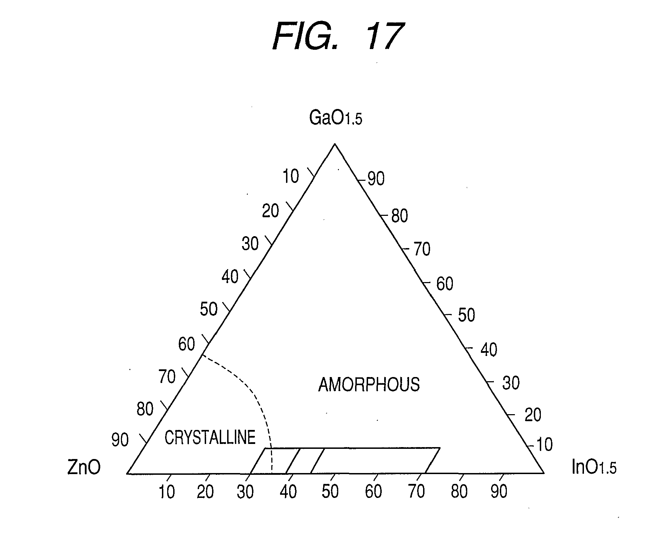

FIG. 17 shows compositional regions in which preferable TFT characteristic are obtained, which are summarized on the ternary phase diagram of In, Ga, and Zn, based on this example.

Next, the TFT which was left in the air for half a year was subjected to a DC bias stress test. To be specific, for 400 seconds, a DC voltage stress of 12 V was applied to the gate electrode and a DC voltage stress of 12 V was applied between the source electrode and the drain electrode. Changes in TFT characteristics were thus evaluated. As a result, it is found that variations in characteristics which are caused by the DC stress were much smaller than those in the case of the conventional In-Ga-Zn-O film.

Table 9 shows a summary of field-effect mobilities, S-values, and threshold shifts caused by the DC stress, which are associated with respective metal compositional ratios in the TFTs obtained in this example. In Table 9, "-" displayed on sections indicating the mobility and the S-value exhibits that a preferable TFT operation was not obtained at the corresponding compositional ratio because of a small current ON/OFF ratio.

**Table 9**

| | Immediately after TFT was produced | | After TFT was left in the air for half a year | | |
|---|---|---|---|---|---|
| In:Ga:Zn [Atom number ratio] | Field-effect mobility [cm²/Vs] | S-value [V/decade] | Field-effect mobility [cm²/Vs] | S-value [V/decade] | Threshold shift [V] |
| 30:10:60 | 13.5 | 0.7 | 13.5 | 0.7 | 0.8 |
| 35:10:55 | 13.6 | 0.6 | 13.6 | 0.6 | 0.7 |
| 50:10:40 | 13.5 | 0.8 | 13.5 | 0.8 | 0.5 |
| 25:5:70 | - | - | - | - | - |
| 31:5:64 | 15 | 0.4 | 13 | 0.4 | 0.8 |
| 38:5:57 | 15 | 0.25 | 15 | 0.25 | 0.7 |
| 47.5:5:47.5 | 15 | 0.35 | 15 | 0.35 | 0.7 |
| 55:5:40 | 15 | 0.5 | 15 | 0.5 | 0.5 |
| 60:5:35 | - | - | - | - | - |
| 30:3:67 | 12 | 0.8 | - | - | - |
| 33.5:3:63.5 | 15.5 | 0.3 | 16.5 | 0.32 | 0.8 |
| 38.5:3:58.5 | 16 | 0.2 | 16..5 | 0.21 | 0.7 |
| 48.5:3:48.5 | 15.5 | 0.32 | 16 | 0.34 | 0.5 |
| 55:3:42 | 15.5 | 0.45 | 16 | 0.47 | 0.5 |
| 60:3:37 | 14 | 0.8 | - | - | - |

FIG. 5 shows TFT carrier mobilities summarized on the ternary phase diagram of In, Ga, and Zn based on Examples 1 to 4.

Hereinafter, the TFT evaluation results obtained in Examples 1 to 4 will be summarized using FIG. 18.

When the In-Ga-Zn-O thin film having the composition in the compositional region surrounded by the lines joining the points (1), (2), (8), and (7) on the phase diagram shown in FIG. 18 is used as the channel layer, it is possible to provide a transistor having a field-effect mobility higher than that of a conventional one. To be specific, a transistor whose field-effect mobility is 7 cm²/Vs or higher can be provided.

Further, when the In-Ga-Zn-O thin film having the composition in the compositional region which is within the above-mentioned compositional region and surrounded by the lines joining the points (1), (2), (6), and (5) on the phase diagram shown in FIG. 18 is particularly used as the channel layer, it is possible to provide a transistor having excellent transistor characteristics and a preferable DC bias stress resistance as compared with a conventional one. To be specific, a transistor whose field-effect mobility is 12 cm²/Vs or higher, S-value is 1 V/decade or lower, and threshold shift caused by the DC bias stress is 1 V or lower can be provided.

Further, when the In-Ga-Zn-O thin film having the composition in the compositional region which is within the above-mentioned compositional region and surrounded by the lines joining the points (1), (2), (4), and (3) on the phase diagram shown in FIG. 18 is particularly used as the channel layer, it is possible to provide a transistor whose field effect mobility is large and S-value is extremely small. To be specific, a transistor whose field-effect mobility is 15 cm²/Vs or higher and S-value is 0.5 V/decade or lower can be provided.

Further, when the In-Ga-Zn-O thin film having the composition in the compositional region which is within the above-mentioned compositional region and surrounded by the lines joining the points (3), (4), (6), and (5) on the phase diagram shown in FIG. 18 is particularly used as the channel layer, it is possible to provide a transistor which is excellent in temporal stability and has transistor characteristics superior to a conventional one and a DC bias stress resistance higher than that in a conventional case.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

This application claims priority benefits of Japanese Patent Application Nos. 2005-271118 filed September 16, 2005, 2006-075054 filed March 17, 2005, and 2006-224309 filed August 21, 2006, the entire disclosure of which are incorporated herein by reference in their entirety.

## Claims

1. A field-effect transistor, comprising a channel made of an oxide semiconductor material including In and Zn,
wherein an atomic compositional ratio expressed by In/(In + Zn) is not less than 35 atomic% and not more than 55 atomic%; and
wherein
Ga is not included in the oxide semiconductor material or
an atomic compositional ratio expressed by
Ga/(In + Zn + Ga) is 30 atomic% or lower when Ga is included therein.

2. A field-effect transistor according to claim 1, wherein the atomic compositional ratio expressed by Ga/(In + Zn + Ga) is 15 atomic% or lower.

3. A field-effect transistor according to claim 1, wherein the atomic compositional ratio expressed by Ga/(In + Zn + Ga) is 5 atomic% or lower.

4. A field-effect transistor according to claim 1, wherein the atomic compositional ratio expressed by Ga/(In + Zn + Ga) is not less than 5 atomic% and not more than 15 atomic%.

5. A field-effect transistor according to claim 1, wherein the atomic compositional ratio expressed by In/(In + Zn) is 40 atomic% or more.

6. A field-effect transistor according to claim 1, wherein the atomic compositional ratio expressed by In/(In + Zn) is 50 atomic% or lower.
